# EUROPÄISCHE PATENTSCHRIFT

(11) **EP 3 225 021 B1**
(45) Veröffentlichungstag und Bekanntmachung des Hinweises auf die Patenterteilung: **13.03.2019**
(21) Anmeldenummer: 16757602.4
(22) Anmeldetag: 17.08.2016
(51) Int. Cl.: H04N 5/232, H04N 5/225, G02B 27/64, G02B 13/00

(54) **MULTIAPERTURABBILDUNGSVORRICHTUNG, ABBILDUNGSSYSTEM UND VERFAHREN ZUM BEREITSTELLEN EINER MULTIAPERTURABBILDUNGSVORRICHTUNG**
MULTI-APERTURE IMAGING DEVICE, IMAGING SYSTEM AND METHOD FOR MAKING AVAILABLE A MULTI-APERTURE IMAGING DEVICE
DISPOSITIF DE REPRODUCTION MULTIOUVERTURE, SYSTÈME DE REPRODUCTION ET PROCÉDÉ DE FOURNITURE D'UN DISPOSITIF DE REPRODUCTION MULTIOUVERTURE

(30) Priorität: 19.08.2015 DE 102015215840
(43) Veröffentlichungstag der Anmeldung: 04.10.2017
(73) Patentinhaber: Fraunhofer-Gesellschaft zur Förderung der angewandten Forschung e.V., 80686 München (DE)
(72) Erfinder: WIPPERMANN, Frank, 98617 Meiningen (DE); BRÜCKNER, Andreas, 07743 Jena (DE); BRÄUER, Andreas, 07646 Schlöben (DE); OBERDÖRSTER, Alexander, 07749 Jena (DE)
(74) Vertreter: Schenk, Markus
(86) Internationale Anmeldenummer: PCT/EP2016/069521
(87) Internationale Veröffentlichungsnummer: WO 2017/029329

(56) Entgegenhaltungen:
- WO-A1-2015/058150
- DE-B3-102014 213 371
- US-A1- 2015 109 468
- WIPPERMANN F C ET AL: "Novel multi-aperture approach for miniaturized imaging systems", OPTICAL SENSING II, SPIE, 1000 20TH ST. BELLINGHAM WA 98225-6705 USA, Bd. 9760, 15. März 2016 (2016-03-15), Seiten 97600S-97600S, XP060070249, ISSN: 0277-786X, DOI: 10.1117/12.2211698 ISBN: 978-1-62841-971-9

## Beschreibung

Die vorliegende Erfindung bezieht sich auf eine Multiaperturabbildungsvorrichtung, auf ein Abbildungssystem und auf ein Verfahren zum Bereitstellen einer Multiaperturabbildungsvorrichtung. Die vorliegende Erfindung bezieht sich ferner auf Multiaperturabbildungssysteme mit linearer Kanalanordnung und kleiner oder kleinster Baugröße.

Konventionelle Kameras besitzen einen Abbildungskanal, der das gesamte Objektfeld abbildet. Die Kameras besitzen adaptive Komponenten, die eine relative laterale, zweidimensionale Verschiebung zwischen Objektiv und Bildsensor zur Realisierung einer optischen Bildstabilisierungsfunktion ermöglichen. Multiaperturabbildungssysteme mit linearer Kanalanordnung bestehen aus mehreren Abbildungskanälen, die jeweils nur einen Teil des Objekts aufnehmen und einen Umlenkspiegel enthalten.

In DE 10 2014 213371 B3 ist eine Vorrichtung zur Erfassung eines Objektbereichs mit einem flachen Gehäuse mit einer ersten Hauptseite, einer zweiten Hauptseite, einer Randseite und einer Multiaperturvorrichtung mit einer Mehrzahl von lateral nebeneinander angeordneten und der Randseite zugewandten optischen Kanälen beschrieben.

In US 2015/109468 A1 ist ein Verfahren und eine Vorrichtung für das Steuern des Auslesens von Zeilen von Pixelwerten von den Sensoren, die mit verschiedenen optische Ketten entsprechen, beschrieben, um Abschnitte desselben Bildbereichs zu erfassen.

In WO 2015/058150 A1 ist ein Kamera Verfahren und eine Vorrichtung beschrieben, bei denen die Kameravorrichtung mehrere optische Ketten umfasst. In verschiedenen Ausführungsformen umfassen zwei oder mehrere der optischen Ketten Lichtumleitungsvorrichtungen, wie Spiegel oder Prismen.

Wünschenswert wären Konzepte zum mehrkanaligen Erfassen von Objektbereichen oder Gesichtsfeldern, die eine kompakte Realisierung ermöglichen.

Die Aufgabe der vorliegenden Erfindung besteht deshalb darin, eine Multiaperturabbildungsvorrichtung, ein Abbildungssystem und ein Verfahren zum Bereitstellen einer Multiaperturabbildungsvorrichtung zu schaffen, das eine kompakte, d.h. einen geringen Bauraum aufweisende Realisierung insbesondere hinsichtlich der Erzielung einer geringen Bauhöhe ermöglicht.

Diese Aufgabe wird durch den Gegenstand der unabhängigen Patentansprüche gelöst.

Eine Erkenntnis der vorliegenden Erfindung besteht darin, erkannt zu haben, dass obige Aufgabe dadurch gelöst werden kann, dass eine optische Bildstabilisierung eines von der Multiaperturabbildungsvorrichtung erfassten Bildes entlang einer Bildachse durch Erzeugen einer Rotationsbewegung einer Strahlumlenkeinrichtung, die den Strahlengang von optischen Kanälen umlenkt, erhalten werden kann, so dass eine translatorische Bewegung zwischen einem Abbildungskanal und einem Bildsensor entlang der entsprechenden Bildrichtung reduziert oder vermieden werden kann. Ein so reduzierter Umfang von translatorischen Bewegungen ermöglicht eine reduzierte Bauhöhe und mithin eine kompakte, d.h. einen geringen bauraumaufweisende und insbesondere hinsichtlich der Erzielung einer geringen Bauhöhe oder Dicke vorteilhafte Realisierung der Multiaperturabbildungsvorrichtung.

Gemäß einem Ausführungsbeispiel umfasst eine Multiaperturabbildungsvorrichtung einen einem Bildsensor, ein Array von optischen Kanälen, eine Strahlumlenkeinrichtung und einen optischen Bildstabilisator. Jeder optische Kanal des Arrays von optischen Kanälen umfasst eine Optik zur Abbildung eines Teilgesichtsfeldes eines Gesamtgesichtsfeldes auf einen Bildsensorbereich des Bildsensors. die Strahlumlenkeinrichtung ist ausgebildet, um einen Strahlengang der optischen Kanäle umzulenken. Der optische Bildstabilisator ist konfiguriert, um für eine Bildstabilisierung entlang einer ersten Bildachse eine translatorische Relativbewegung zwischen dem Bildsensor und dem Array zu erzeugen und, um zur Bildstabilisierung entlang einer zweiten Bildachse eine Rotationsbewegung der Strahlumlenkeinrichtung zu erzeugen. Basierend auf der Rotationsbewegung kann ein geringer Bauraumbedarf entlang der zweiten Bildachse erhalten werden. Ferner kann basierend auf der Rotationsbewegung eine Konfiguration, bei der ein Aktor zum Erzeugen einer translatorischen Bewegung entlang einer ersten Achse zwischen einem Bildsensor und einer Optik von einem Aktor zum Erzeugen einer translatorischen Bewegung entlang einer zweiten Achse mitbewegt werden muss, vermieden werden.

Gemäß einem weiteren Ausführungsbeispiel umfasst der Bildstabilisator zumindest einen Aktor. Der zumindest eine Aktor ist zumindest teilweise zwischen zwei Ebenen angeordnet, die durch Seiten eines Quaders aufgespannt werden, wobei die Seiten des Quaders zueinander sowie zu einer Zeilenerstreckungsrichtung des Arrays und eines Teils des Strahlengangs der optischen Kanäle zwischen dem Bildsensor und der Strahlumlenkeinrichtung parallel ausgerichtet sind und dessen Volumen minimal ist und dennoch den Bildsensor, das Array und die Strahlumlenkeinrichtung umfasst. Ist eine Richtung, beispielsweise eine Dickenrichtung, senkrecht zu zumindest einer Ebene ermöglicht dies eine geringe Dicke der Multiaperturabbildungsvorrichtung oder eines Systems umfassend die Multiaperturabbildungsvorrichtung.

Gemäß einem weiteren Ausführungsbeispiel umfasst eine Multiaperturabbildungsvorrichtung eine Fokussiereinrichtung umfassend zumindest einen Aktor zum Einstellen des Fokus der Multiaperturabbildungsvorrichtung. Die Fokussiereinrichtung ist zumindest teilweise zwischen zwei Ebenen angeordnet, die durch Seiten eines Quaders aufgespannt werden, wobei die Seiten des Quaders zueinander sowie zu einer Zeilenerstreckungsrichtung des Arrays und eines Teils des Strahlengangs der optischen Kanäle zwischen dem Bildsensor und der Strahlumlenkeinrichtung parallel ausgerichtet sind und dessen Volumen minimal ist und dennoch den Bildsensor, das Array und die Strahlumlenkeinrichtung umfasst. Vorteilhaft daran ist, dass durch Anordnen des Aktors in der Ebene ein Bauraumbedarf entlang einer Richtung senkrecht zu der Ebene gering sein kann.

Gemäß einem weiteren Ausführungsbeispiel ist das Array von optischen Kanälen einzeilig gebildet. Eine einzeilige Ausbildung des Arrays von optischen Kanälen ermöglicht eine geringe räumliche Ausdehnung des Arrays und/oder der Multiaperturabbildungsvorrichtung entlang einer Richtung senkrecht zu einer Zeilenerstreckungsrichtung des Arrays, was weiter reduzierte Abmessungen der Vorrichtungen ermöglichen kann.

Weitere Ausführungsbeispiele beziehen sich auf ein Abbildungssystem und auf ein Verfahren zum Bereitstellen einer Multiaperturabbildungsvorrichtung.

Weitere vorteilhafte Ausführungsformen sind der Gegenstand der abhängigen Patentansprüche.

Bevorzugte Ausführungsbeispiele der vorliegenden Erfindung werden nachfolgend Bezug nehmend auf die beiliegenden Zeichnungen erläutert. Es zeigen:
- Fig. 1a: eine schematische Ansicht einer Multiaperturabbildungsvorrichtung gemäß einem Ausführungsbeispiel;
- Fig. 1b: eine schematische Ansicht einer Multiaperturabbildungsvorrichtung gemäß einem Ausführungsbeispielbei der ein Aktor mit einem Bildsensor verbunden ist;
- Fig. 2a: eine schematische Seitenschnittansicht einer weiteren Multiaperturabbildungsvorrichtung gemäß einem Ausführungsbeispiel;
- Fig. 2b: zeigt eine schematische Seitenschnittansicht der Multiaperturabbildungsvorrichtung aus Fig. 2a
- Fig. 3: eine schematische Aufsicht auf eine Multiaperturabbildungsvorrichtung bei der eine Strahlumlenkeinrichtung verschiedene Strahlumlenkelemente umfasst, gemäß einem Ausführungsbeispiel;
- Fig. 4: eine schematische perspektivische Ansicht einer Multiaperturabbildungsvorrichtung mit einzeilig angeordneten optischen Kanälen, gemäß einem Ausführungsbeispiel;
- Fig. 5a: eine schematische Darstellung einer Strahlumlenkeinrichtung, die gemäß einem Ausführungsbeispiel als Array von Facetten gebildet ist;
- Fig. 5b: eine schematische Ansicht der Strahlumlenkeinrichtung gemäß einem Ausführungsbeispiel, bei der Facetten verglichen mit der Darstellung in Fig. 5a eine voneinander verschieden Sortierung aufweisen;
- Fig. 6: eine schematische perspektivische Darstellung eines Abbildungssystems gemäß einem Ausführungsbeispiel;
- Fig. 7: eine schematische Darstellung eines Gesamtgesichtsfelds gemäß einem Ausführungsbeispiel, wie es beispielsweise mit einer hierin beschriebenen Multiaperturabbildungsvorrichtung erfassbar ist;
- Fig. 8: eine schematische perspektivische Ansicht einer tragbaren Vorrichtung, die zwei Multiaperturabbildungsvorrichtungen umfasst, gemäß einem Ausführungsbeispiel; und
- Fig. 9: einen schematischen Aufbau umfassend eine erste Multiaperturabbildungsvorrichtung und eine zweite Multiaperturabbildungsvorrichtung mit einem gemeinsamen Bildsensor.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

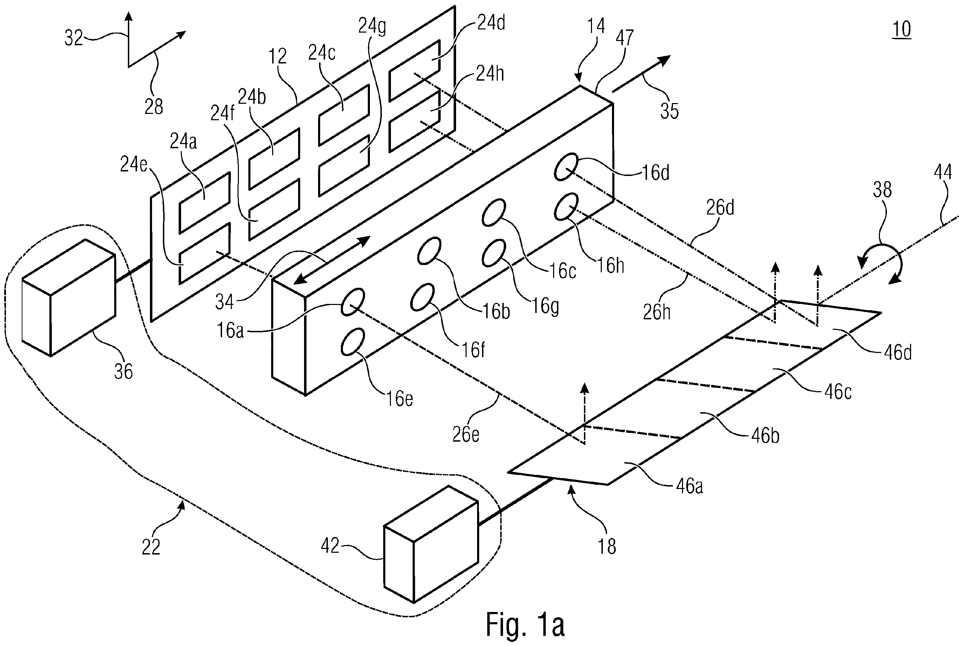

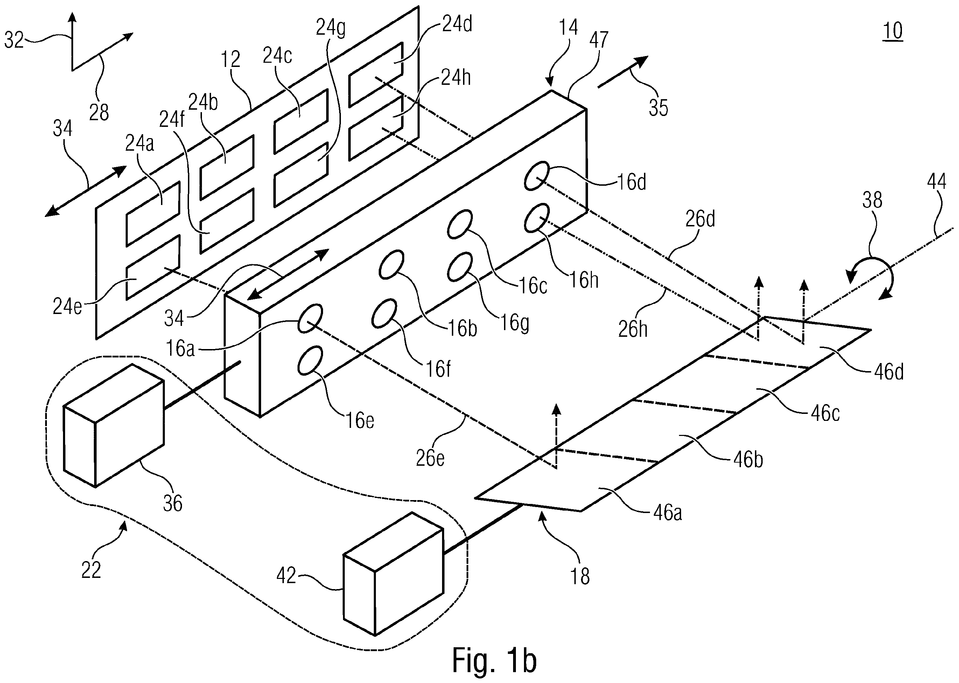

Fig. 1 zeigt eine schematische Ansicht einer Multiaperturabbildungsvorrichtung 10 gemäß einem Ausführungsbeispiel. Die Multiaperturabbildungsvorrichtung 10 umfasst einen Bildsensor 12, ein Array 14 von optischen Kanälen 16a-h, eine Strahlumlenkeinrichtung 18 und einen optischen Bildstabilisator 22. Jeder optische Kanal 16a-h umfasst eine Optik zur Abbildung eines Teilgesichtsfeldes eines Gesamtgesichtsfeldes auf einen Bildsensorbereich 24a-h des Bildsensors 12. Optische Kanäle können als ein Verlauf von Strahlengängen verstanden werden. Die Strahlengänge können zumindest eine Optik aufweisen, die in dem Array 14 angeordnet ist. Die einzelnen optischen Kanäle können jeweils eine vollständige Abbildungsoptik bilden und mindestens einer optischer Komponente bzw. Optik, etwa eine refraktive, diffraktive oder hybride Linse aufweisen und können einen Ausschnitt des mit der Multiaperturabbildungsvorrichtung insgesamt aufgezeichneten Gesamtobjekts abbilden. Bezüglich der optischen Kanäle kann eine Aperturblende angeordnet sein.

Die Bildsensorbereiche 24a-h können beispielsweise jeweils aus einem Chip gebildet sein, der ein entsprechendes Pixelarray umfasst, wobei die Bildsensorbereiche auf einem gemeinsamen Substrat bzw. einem gemeinsamen Schaltungsträger wie einer gemeinsamen Platine oder einem gemeinsamen Flexboard montiert sein können. Alternativ wäre es natürlich auch möglich, dass die Bildsensorbereiche 24a-h jeweils aus einem Teil eines gemeinsamen Pixelarrays, das sich kontinuierlich über die Bildsensorbereiche 24a-h erstreckt, gebildet sind, wobei das gemeinsame Pixelarray beispielsweise auf einem einzelnen Chip gebildet ist. Beispielsweise werden dann lediglich die Pixelwerte des gemeinsamen Pixelarrays in den Bildsensorbereichen 24a-h ausgelesen. Verschiedene Mischungen dieser Alternativen sind natürlich ebenfalls möglich, wie z.B. das Vorhandensein eines Chips für zwei oder mehr Kanäle und eines weiteren Chips für wiederum andere Kanäle oder dergleichen. In dem Fall mehrerer Chips des Bildsensors 12 können diese beispielsweise auf einer oder mehreren Platinen oder Schaltungsträgern montiert sein, wie z.B. alle gemeinsam oder gruppenweise oder dergleichen.

Die Strahlumlenkeinrichtung 18 ist ausgebildet, um einen Strahlengang 26 der optischen Kanäle 16a-h umzulenken. Der Bildstabilisator 22 ist ausgebildet, um basierend auf einer Relativbewegung zwischen dem Bildsensor 12, dem Array 14 und der Umlenkeinrichtung 18 eine optische Bildstabilisierung entlang einer ersten Bildachse 28 und entlang einer zweiten Bildachse 32 zu ermöglichen. Die erste Bildachse 28 und die zweite Bildachse 32 können von einer Anordnung oder Orientierung der Bildsensorbereiche 24a-h bzw. des Bildsensors 12 beeinflusst sein. Gemäß einem Ausführungsbeispiel sind die Bildachsen 28 und 32 senkrecht zueinander angeordnet und/oder mit Erstreckungsrichtungen von Pixeln der Bildsensorbereiche 24a-d übereinstimmen. Die Bildachsen 28 und 32 können alternativ oder zusätzlich eine Orientierung angeben, entlang der ein Teilgesichtsfeld oder das Gesamtgesichtsfeld abgetastet oder erfasst werden. Vereinfacht ausgedrückt kann es sich bei den Bildachsen 28 und 32 um eine erste bzw. zweite Richtung in einem von der Multiaperturabbildungsvorrichtung 10 erfassten Bild handeln. Die Bildachsen 28 und 32 weisen bspw. einen Winkel von ≠ 0° zueinander auf, beispielsweise senkrecht zueinander im Raum angeordnet sein.

Eine optische Bildstabilisierung kann vorteilhaft sein, wenn während eines Erfassungsvorgangs, während dem Teilgesichtsfelder oder das Gesamtgesichtsfeld erfasst werden, die Multiaperturabbildungsvorrichtung 10 gegenüber dem Objektbereich, dessen Gesichtsfeld erfasst wird, bewegt wird. Der optische Bildstabilisator 22 kann ausgebildet sein, um dieser Bewegung zumindest teilweise entgegenzuwirken, um ein Verwackeln des Bildes zu reduzieren oder zu verhindern. Hierfür kann der optische Bildstabilisator 22 ausgebildet sein, um eine translatorische Relativbewegung 34 zwischen dem Bildsensor 12 und dem Array 14 zu erzeugen. Hierfür kann der optische Bildstabilisator 22 einen Aktor 36 aufweisen, der ausgebildet ist, um die translatorische Relativbewegung 34 zu erzeugen. Obwohl der Aktor 36 so dargestellt ist, dass er das Array 14 translatorisch verschiebt oder bewegt, kann der Aktor 36 gemäß weiteren Ausführungsbeispielen alternativ oder zusätzlich mit dem Bildsensor 12 verbunden sein und ausgebildet sein, um den Bildsensor 12 relativ zu dem Array 14 zu bewegen. Die Relativbewegung 34 kann parallel zu einer Zeilenerstreckungsrichtung 35 und senkrecht zu den Strahlengängen 26 ausführbar sein. Es kann jedoch vorteilhaft sein, das Array 14 gegenüber dem Bildsensor 12 translatorisch in Bewegung zu versetzen, um beispielsweise eine elektrische Verschaltung des Bildsensors 12 gegenüber weiteren Komponenten mechanisch wenig oder nicht zu belasten.

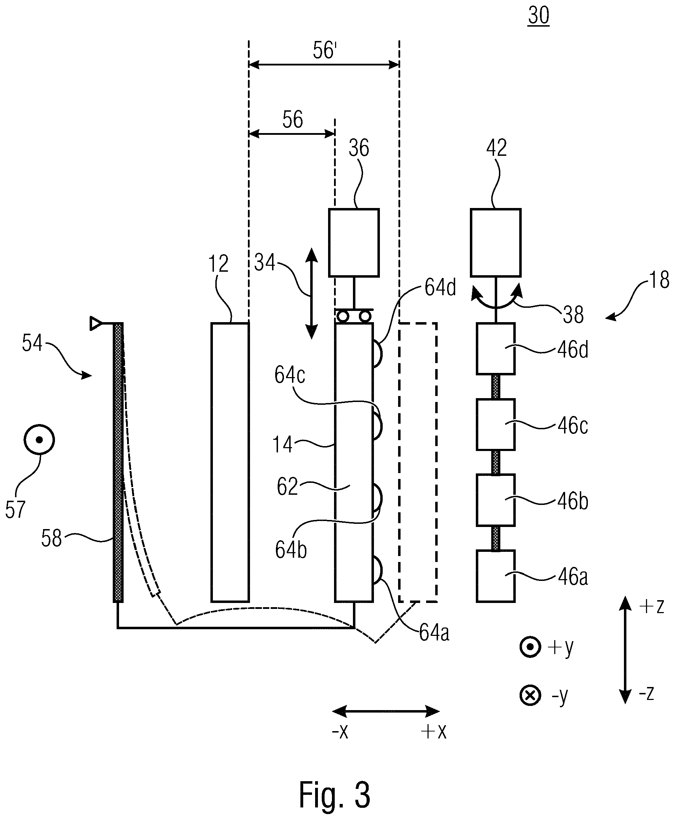

Der optische Bildstabilisator 22 kann ausgebildet sein, um eine Rotationsbewegung 38 der Strahlumlenkeinrichtung 18 zu erzeugen oder zu ermöglichen. Hierfür kann der optische Bildstabilisator 22 beispielsweise einen Aktor 42 umfassen, der ausgebildet ist, um die Rotationsbewegung 38 zu erzeugen. Basierend auf der translatorischen Relativbewegung 34 kann eine optische Bildstabilisierung entlang einer Bildrichtung parallel hierzu, beispielsweise entlang oder entgegengesetzt zu der Bildachse 28 erhalten werden. Basierend auf der Rotationsbewegung 38 kann eine optische Bildstabilisierung entlang einer Bildrichtung erhalten werden, die senkrecht zu einer Rotationsachse 44 der Rotationsbewegung 38 in einer Hauptseitenebene des Bildsensors 12 angeordnet ist, etwa entlang der Bildachse 32. Eine Hauptseite kann als Seite verstanden werden, die eine große oder größte Abmessung verglichen mit anderen Seiten aufweist. Alternativ oder zusätzlich kann eine Fokussiereinrichtung, wie sie bspw. in Zusammenhang mit Fig. 3 beschrieben ist, angeordnet sein, die ausgebildet ist, um einen Fokus der Multiaperturabbildungsvorrichtung zu ändern.

Vereinfacht ausgedrückt kann anstelle einer translatorischen Bewegung senkrecht zu der Relativbewegung 34 die Rotationsbewegung 38 genutzt werden, um die optische Bildstabilisierung entlang der zweiten Bildachse 32 zu erhalten. Dies ermöglicht, dass ein Bauraumbedarf zum Ermöglichen der translatorischen Relativbewegung senkrecht zu der Relativbewegung 34 eingespart werden kann. Beispielsweise kann die translatorische Relativbewegung senkrecht zu einer Dickenrichtung der Vorrichtung angeordnet sein, so dass die Vorrichtung mit einer geringen Dicke, d.h. dünn ausgeführt werden kann. Dies bietet insbesondere im Bereich mobiler Vorrichtungen Vorteile, da diese mit einem flachen Gehäuse ausgeführt werden können.

Das Array 14 kann beispielsweise einen Träger 47 aufweisen, durch den die optischen Kanäle 16a-h hindurchlaufen. Hierfür kann der Träger 47 beispielsweise opak ausgebildet sein und transparente Bereiche für die optischen Kanäle 16a-h aufweisen. Innerhalb der oder benachbart zu den transparenten Bereichen und/oder an Endbereichen hiervon können die Optiken der optischen Kanäle 16a-h angeordnet sein. Alternativ oder zusätzlich kann der Träger 47 transparent gebildet sein und beispielsweise ein Polymermaterial und/oder ein Glasmaterial aufweisen. An einer Oberfläche des Trägers 47 können Optiken (Linsen) angeordnet sein, die die Abbildung des jeweiligen Teilgesichtsfeldes des Gesamtgesichtsfeldes auf den jeweiligen Bildsensorbereich 24a-h des Bildsensors beeinflussen.

Die Aktoren 36 und/oder 42 können beispielsweise als pneumatischer Aktor, als hydraulischer Aktor, als piezoelektrischer Aktor, als Gleichstrommotor, als Schrittmotor (Stepper-Motor), als thermisch aktuierter Aktor, als elektrostatischer Aktor, als elektrostriktiver Aktor, als magnetostriktiver Aktor oder als Tauchspulenantrieb gebildet sein.

Die Strahlumlenkeinrichtung 18 kann bereichsweise reflektierend gebildet sein. Beispielsweise kann die Strahlumlenkeinrichtung 18 Bereiche oder Strahlumlenkelemente 46a-d umfassen, die ausgebildet sind, um die Strahlengänge 26 so umzulenken, dass die umgelenkten Strahlengänge einen von einander verschiedenen Winkel aufweisen und einen von einander verschiedenes Teilgesichtsfeld eines Gesamtgesichtsfeldes erfassen. Die unterschiedlichen Winkel können durch die Strahlumlenkeinrichtung 18 und/oder die Optiken der optischen Kanäle 16a-h erzeugt werden. Beispielsweise können die Bereiche 46a-d als Facetten eines Facettenspiegels gebildet sein. Die Facetten können eine von einander verschiedene Neigung bezüglich des Arrays 14 aufweisen. Dies kann eine Ablenkung, Beeinflussung, Steuerung und/oder Streuung der Strahlengänge 26 hin zu voneinander verschieden angeordneten Teilgesichtsfeldern ermöglichen. Alternativ kann die Strahlumlenkeinrichtung 18 als einseitig oder beidseitig reflektierend ausgebildete Fläche ausgebildet sein, beispielsweise als Spiegel. Die Fläche kann eben oder abschnittsweise kontinuierlich gekrümmt oder eben gebildet sein und/oder abschnittsweise diskontinuierlich gekrümmt oder eben gebildet sein. Eine Ablenkung der Strahlengänge 26 kann alternativ oder zusätzlich mittels der Optiken der optischen Kanäle 16a-h erhalten werden.

In anderen Worten kann der Spiegel (Strahlumlenkeinrichtung) über den Bereich aller Kanäle eben sein, ein kontinuierliches oder diskontinuierliches Profil aufweisen und/oder stückweise eben, d.h. facettiert, sein, wobei die Übergänge zwischen einzelnen kontinuierlichen oder diskontinuierlichen Profilen zusätzlich lokale Maskierungen zur Herabsetzung der Reflektivität oder mechanische Strukturen aufweisen können, um Bildfehler zu reduzieren bzw. um eine Versteifung des Aufbaus zu ermöglichen, so dass bewegungsinduzierte oder thermisch induzierte Bildfehler gering sein können.

Ein Umschalten zwischen der ersten Position und der zweiten Position der Strahlumlenkeinrichtung kann translativ entlang der Drehachse 44 erfolgen. Eine Bewegung entlang der Rotationsachse 44 kann kontinuierlich oder diskontinuierlich, beispielsweise bistabil oder mehrfach stabil ausgeführt sein. Dies kann beispielsweise als positionsdiskrete Stellungen verstanden werden, zwischen denen die Strahlumlenkeinrichtung 18 bewegt wird. Einfach stabile, bistabile oder mehrfach stabile Positionen können beispielsweise erhalten werden, indem der Aktor 42 oder ein anderer Aktor als Schrittmotor ausgebildet ist. Ist die Strahlumlenkeinrichtung 18 beispielsweise ausgebildet, um zwischen zwei Positionen hin und her bewegt zu werden, kann eine der Positionen beispielsweise eine Ruheposition des Aktors sein oder hierauf basieren. Der Aktor kann beispielsweise ausgebildet sein, um die translatorische Bewegung gegenüber einer Federkraft auszuführen, die bei Erreichen der jeweils anderen Position eine Gegenkraft ausübt, die bei einer Wegnahme der Kraft des Aktors die Strahlumlenkeinrichtung wieder zurück in ihre Ausgangsposition bewegt. Das bedeutet, dass eine stabile Position auch in Bereichen eines Kräftediagramms erhalten werden kann, die kein lokales Kräfteminimum aufweisen. Beispielsweise kann es sich um ein Kräftemaximum handeln. Alternativ oder zusätzlich kann eine stabile Position basierend auf magnetischen oder mechanischen Kräften zwischen der Strahlumlenkeinrichtung 18 und einem benachbarten Gehäuse oder Substrat erhalten werden. Das bedeutet, der Aktor 42 oder der andere Aktor zum translatorischen Bewegen der Strahlumlenkeinrichtung kann ausgebildet sein, um die Strahlumlenkeinrichtung in eine bistabile oder mehrfach stabile Position zu bewegen. Alternativ können für bistabile Anordnungen der Positionen einfache mechanische Anschläge vorgesehen sein, die zwei Endpositionen definieren, zwischen denen eine Positionsschaltung in den definierten Endlagen erfolgt.

Fig. 1b zeigt eine schematische Ansicht einer Multiaperturabbildungsvorrichtung 10' gemäß einem Ausführungsbeispiel. Die Multiaperturabbildungsvorrichtung 10' ist gegenüber der Multiaperturabbildungsvorrichtung 10 dahingehend modifiziert, dass der Aktor 36 mit dem Bildsensor 12 mechanisch verbunden ist und ausgebildet ist, um den Bildsensor 12 relativ zu dem Array 14 zu bewegen. Die Relativbewegung 34 kann parallel zu der Zeilenerstreckungsrichtung 35 und senkrecht zu den Strahlengängen 26 ausführbar sein.

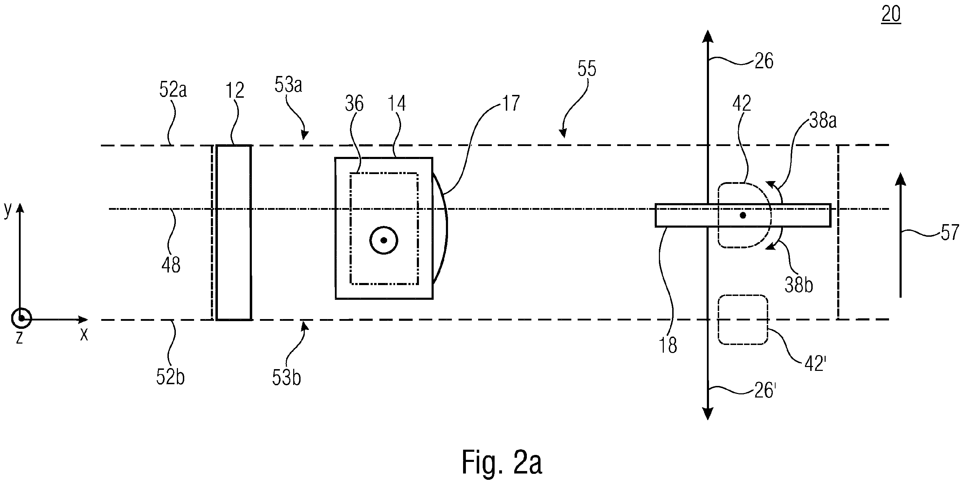

Fig. 2a zeigt eine schematische Seitenschnittansicht einer Multiaperturabbildungsvorrichtung 20 gemäß einem Ausführungsbeispiel. Die Multiaperturabbildungsvorrichtung 20 kann bspw. die Multiaperturabbildungsvorrichtung 10 dahingehend modifizieren, dass die Aktoren 36 und/oder 42 so angeordnet sind, dass sie zumindest teilweise zwischen zwei Ebenen 52a und 52b angeordnet ist, die durch Seiten 53a und 53b eines Quaders 55 aufgespannt werden. Die Seiten 53a und 53b des Quaders 55 können parallel zueinander sowie parallel zu der Zeilenerstreckungsrichtung des Arrays und eines Teils des Strahlengangs der optischen Kanäle zwischen dem Bildsensor und der Strahlumlenkeinrichtung parallel ausgerichtet sein. Das Volumen des Quaders 55 ist minimal und umfasst dennoch den Bildsensor 12, das Array 14 und die Strahlumlenkeinrichtung 18 sowie deren betriebsbedingte Bewegungen. Optische Kanäle des Arrays 14 weisen eine Optik 17 auf, die für jeden optischen Kanal gleich oder verschieden von einander gebildet sein kann.

Ein Volumen der Multiaperturabbildungsvorrichtung kann einen geringen oder minimalen Bauraum zwischen den Ebenen 52a und 52b aufweisen. Entlang der lateralen Seiten oder Erstreckungsrichtungen der Ebenen 52a und/oder 52b kann ein Bauraum der Multiaperturabbildungsvorrichtung groß oder beliebig groß sein. Das Volumen des virtuellen Quaders ist bspw. von einer Anordnung des Bildsensors 12, des einzeiligen Arrays 14 und der Strahlumlenkeinrichtung beeinflusst, wobei die Anordnung dieser Komponenten gemäß der hierin beschriebenen Ausführungsbeispiele so erfolgen kann, dass der Bauraum dieser Komponenten entlang der Richtung senkrecht zu den Ebenen und mithin der Abstand der Ebenen 52a und 52b zueinander gering oder minimal wird. Gegenüber anderen Anordnungen der Komponenten kann das Volumen und/oder der Abstand anderer Seiten des virtuellen Quaders vergrößert sein.

Durch gepunktete Linien ist der virtueller Quader 55 dargestellt. Die Ebenen 52a und 52b können zwei Seiten des virtuellen Quaders 55 umfassen oder dadurch aufgespannt sein. Eine Dickenrichtung 57 der Multiaperturabbildungsvorrichtung 20 kann normal zu den Ebenen 52a und/oder 52b und/oder parallel zu der y-Richtung angeordnet sein.

Der Bildsensor 12, das Array 14 und die Strahlumlenkeinrichtung 18 können so angeordnet sein, dass ein senkrechter Abstand zwischen den Ebenen 52a und 52b entlang der Dickenrichtung 57, der vereinfachend jedoch ohne einschränkende Wirkung als Höhe des Quaders bezeichnet werden kann, minimal ist, wobei auf eine Minimierung des Volumens, das bedeutet der anderen Abmessungen des Quaders verzichtet werden kann. Eine Ausdehnung des Quaders 55 entlang der Richtung 57 kann minimal und im Wesentlichen durch die Ausdehnung der optischen Komponenten der Abbildungskanäle, d. h., des Arrays 14, des Bildsensors 12 und der Strahlumlenkeinrichtung 18 entlang der Richtung 57 vorgegeben sein.

Ein Volumen der Multiaperturabbildungsvorrichtung kann einen geringen oder minimalen Bauraum zwischen den Ebenen 52a und 52b aufweisen. Entlang der lateralen Seiten oder Erstreckungsrichtungen der Ebenen 52a und/oder 52b kann ein Bauraum der Multiaperturabbildungsvorrichtung groß oder beliebig groß sein. Das Volumen des virtuellen Quaders ist bspw. von einer Anordnung des Bildsensors 12, des einzeiligen Arrays 14 und der Strahlumlenkeinrichtung beeinflusst, wobei die Anordnung dieser Komponenten gemäß der hierin beschriebenen Ausführungsbeispiele so erfolgen kann, dass der Bauraum dieser Komponenten entlang der Richtung senkrecht zu den Ebenen und mithin der Abstand der Ebenen 52a und 52b zueinander gering oder minimal wird. Gegenüber anderen Anordnungen der Komponenten kann das Volumen und/oder der Abstand anderer Seiten des virtuellen Quaders vergrößert sein.

Die Aktoren, etwa der Aktor 36 und/oder 42 der Multiaperturabbildungsvorrichtung können eine Abmessung oder Ausdehnung parallel zu der Richtung 57 aufweisen. Ein Anteil von höchstens 50 %, höchstens 30 % oder höchstens 10 % der Abmessung des Aktors oder der Aktoren kann ausgehend von einem Bereich zwischen den Ebenen 52a und 52b über die Ebene 52a und/oder 52b hinausragen oder aus dem Bereich herausragen. Das bedeutet, dass die Aktoren höchstens unwesentlich über die Ebene 52a und/oder 52b hinausragt. Gemäß Ausführungsbeispielen ragen die Aktoren nicht über die Ebenen 52a und 52b hinaus. Vorteilhaft daran ist, dass eine Ausdehnung der Multiaperturabbildungsvorrichtung 10 entlang der Dickenrichtung bzw. Richtung 57 durch die Aktoren nicht vergrößert wird.

Der Bildstabilisator 22 bzw. die Aktoren 36 und/oder 42 können eine Abmessung oder Ausdehnung parallel zu der Dickenrichtung 57 aufweisen. Ein Anteil von höchstens 50 %, höchstens 30 % oder höchstens 10 % der Abmessung kann ausgehend von einem Bereich zwischen den Ebenen 52a und 52b über die Ebene 52a und/oder 52b hinausragen oder aus dem Bereich herausragen, wie es bspw. für den Aktor 42' dargestellt ist, der eine versetzte Anordnung des Aktors 42 andeutet. Das bedeutet, dass die Aktoren 36 und/oder 42 höchstens unwesentlich über die Ebene 52a und/oder 52b hinausragen. Gemäß Ausführungsbeispielen ragen die Aktoren 36 und/oder 42 nicht über die Ebenen 52a und 52b hinaus. Vorteilhaft daran ist, dass eine Ausdehnung der Multiaperturabbildungsvorrichtung 20 entlang der Dickenrichtung 57 durch die Aktoren 36 bzw. 42 nicht vergrößert wird.

Obwohl hier verwendete Begriffe wie oben, unten, links, rechts, vorne oder hinten zur besseren Anschaulichkeit verwendet werden, sollen diese keinerlei einschränkende Wirkung entfalten. Es versteht sich, dass basierend auf einer Drehung oder Verkippung im Raum diese Begriffe wechselseitig vertauschbar sind. Beispielsweise kann die x-Richtung von dem Bildsensor 12 ausgehend hin zu der Strahlumlenkeinrichtung 18 als vorne oder vorwärts verstanden werden. Eine positive y-Richtung kann beispielsweise als oben verstanden werden. Ein Bereich entlang der positiven oder negativen z-Richtung abseits oder beabstandet des Bildsensors 12, des Arrays 14 und/oder der Strahlumlenkeinrichtung 18 kann als neben der jeweiligen Komponente verstanden werden. Vereinfacht ausgedrückt kann der Bildstabilisator zumindest einen Aktor 36 bzw. 42 umfassen. Der zumindest eine Aktor 36 und/oder 42 kann in der Ebene 48 bzw. zwischen den Ebenen 52a und 52b angeordnet sein.

In anderen Worten können die Aktoren 36 und/oder 42 vor, hinter oder neben dem Bildsensor 12, dem Array 14 und/oder der Strahlumlenkeinrichtung 18 angeordnet sein. Gemäß Ausführungsbeispielen sind die Aktoren 36 und 42 mit einem maximalen Umfang von 50 %, 30 % oder 10 % außerhalb des Bereichs zwischen den Ebenen 52a und 52b angeordnet. Das bedeutet, dass der zumindest eine Aktor 36 und/oder der Bildstabilisator 22 entlang der Dickenrichtung 57 senkrecht zu der Ebene 48 um höchstens 50 % der Abmessung des Aktors 36 bzw. 42 des Bildstabilisators entlang der Dickenrichtung 57 aus der Ebene bzw. dem Bereich zwischen den maximalen Abmessungen 52a-52b herausragt. Dies ermöglicht eine geringe Abmessung der Multiaperturabbildungsvorrichtung 20 entlang der Dickenrichtung 57.

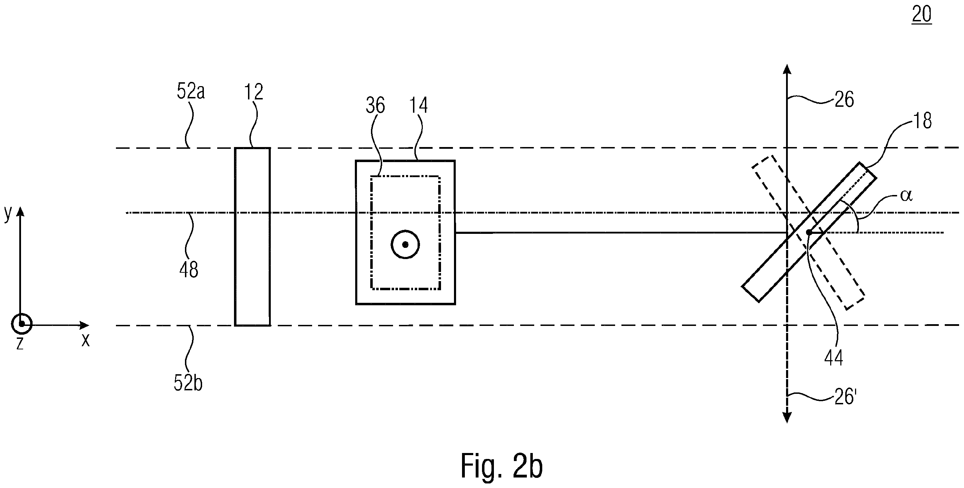

Fig. 2b zeigt eine schematische Seitenschnittansicht der Multiaperturabbildungsvorrichtung 20 wobei die Strahlengänge 26 und 26' verschiedene Blickrichtungen der Multiaperturabbildungsvorrichtung 20 andeuten. Die Multiaperturabbildungsvorrichtung kann ausgebildet sein, um eine Verkippung der Strahlumlenkeinrichtung um eine Winkel α zu verändern, so dass wechselweise unterschiedliche Hauptseiten der Strahlumlenkeinrichtung 18 dem Array 14 zugewandt angeordnet sind. Die Multiaperturabbildungsvorrichtung 20 kann einen Aktor umfassen, der ausgebildet ist, um die Strahlumlenkeinrichtung 18 um die Rotationsachse 44 zu verkippen. Beispielsweise kann der Aktor ausgebildet sein, um die Strahlumlenkeinrichtung 18 in eine erste Stellung zu bewegen, in der die Strahlumlenkeinrichtung 18 den Strahlengang 26 der optischen Kanäle des Arrays 14 in die positive y-Richtung umlenkt. Hierfür kann die Strahlumlenkeinrichtung 18 in der ersten Position, beispielsweise einen Winkel α von > 0° und < 90°, von zumindest 10° und höchstens 80° oder von zumindest 30° und höchstens 50°, beispielsweise 45° aufweisen. Der Aktor kann ausgebildet sein, um die Strahlumlenkeinrichtung in einer zweiten Stellung so um die Rotationsachse 44 auszulenken, dass die Strahlumlenkeinrichtung 18 den Strahlengang der optischen Kanäle des Arrays 14 hin zu der negativen y-Richtung umlenkt, wie es durch den Strahlengang 26' und die gestrichelte Darstellung der Strahlumlenkeinrichtung 18 dargestellt ist. Beispielsweise kann die Strahlumlenkeinrichtung 18 beidseitig reflektierend ausgebildet sein, so dass in der ersten Stellung ein erster Strahlengang 26 bzw. 26' umlenkt oder reflektiert wird.

Fig. 3 zeigt eine schematische Aufsicht auf eine Multiaperturabbildungsvorrichtung 30 gemäß einem Ausführungsbeispiel. Die Multiaperturabbildungsvorrichtung 30 kann gegenüber der Multiaperturabbildungsvorrichtung 10 und/oder 20 dahin gehend modifiziert sein, dass die Multiaperturabbildungsvorrichtung 30 eine Fokussiereinrichtung 54 umfasst, die ausgebildet ist, um einen Fokus der Multiaperturabbildungsvorrichtung 30 zu verändern. Dies kann basierend auf einem veränderlichen Abstand 56 zwischen dem Bildsensor 12 und dem Array 14 erfolgen, wie es durch den Abstand 56' dargestellt ist.

Die Fokussiereinrichtung 54 kann einen Aktor 58 umfassen, der ausgebildet ist, um sich bei einer Aktuierung zu verformen und/oder um eine Relativbewegung zwischen dem Bildsensor 12 und dem Array 14 bereitzustellen. Beispielhaft ist dies für die Multiaperturabbildungsvorrichtung 30 so dargestellt, dass der Aktor 58 ausgebildet ist, um das Array 14 entlang der positiven und/oder negativen x-Richtung gegenüber dem Bildsensor 12 zu verschieben. Beispielsweise kann das Array 14 an einer Seite so gelagert sein, dass es basierend auf einer Aktuierung des Aktors 58 eine Bewegung entlang einer positiven oder negativen x-Richtung erfährt und entlang einer positiven und/oder negativen z-Richtung im Wesentlichen unbewegt bleibt. Eine zusätzliche Bewegung entlang der positiven und/oder negativen z-Richtung für eine optische Bildstabilisierung kann beispielsweise basierend auf einer Aktuierung des Aktors 36 erhalten werden. Gemäß weiteren Ausführungsbeispielen ist der Aktor 58 bzw. die Fokussiereinrichtung 54 ausgebildet, um die Relativbewegung zwischen dem Bildsensor 12 und dem Array 14 entlang der x-Achse basierend auf einer translatorischen Verschiebung des Bildsensors 12 gegenüber dem Array 14 zu erhalten. Gemäß weiteren Ausführungsbeispielen können der Bildsensor 12 und das Array 14 bewegt werden. Gemäß weiteren Ausführungsbeispielen kann die Fokussiereinrichtung 54 zumindest einen weiteren Aktor aufweisen. Beispielsweise können ein erster Aktor und ein zweiter Aktor an zwei gegenüberliegenden Bereichen des Arrays 14 angeordnet sein, so dass bei einer Aktuierung der Aktoren eine Anforderung an eine Lagerung des bewegten Arrays 14 (alternativ oder zusätzlich zu dem Bildsensor 12) reduziert ist. Zusätzlich kann der Aktor 58 oder ein weiterer Aktor ausgebildet sein, um einen Abstand zwischen dem einzeiligen Array 14 und der Strahlumlenkeinrichtung 18 im Wesentlichen oder auch bei Nutzung keines zusätzlichen Aktors exakt konstant zu halten, d. h., die Strahlumlenkeinrichtung 18 in einem Umfang zu bewegen, wie das einzeilige Array 14. Die Fokussiereinrichtung 54 kann ausgebildet sein, um eine Autofokusfunktion durch eine relative translatorische Bewegung (Fokussierungsbewegung) zwischen dem Bildsensor 12 und dem Array 14 entlang einer Flächennormalen des Bildsensors 12 zu ermöglichen. Die Strahlumlenkeinrichtung 18 kann dabei durch entsprechende konstruktive Auslegung oder Nutzung des Aktors 42 oder eines weiteren Aktors simultan zur Fokussierungsbewegung mitbewegt werden. Das bedeutet, dass ein Abstand zwischen dem Array 14 und der Strahlumlenkeinrichtung unverändert bleibt und/oder dass die Strahlumlenkeinrichtung 18 gleichzeitig oder zeitversetzt in einem gleichen oder vergleichbaren Umfang wie die Fokussierungsbewegung bewegt wird, so dass zumindest zu einem Zeitpunkt einer Aufnahme des Gesichtsfeldes durch die Multiaperturabbildungsvorrichtung unverändert verglichen mit einem Abstand vor einer Veränderung des Fokus ist. Dies kann derart erfolgen, dass die Strahlumlenkeinrichtung 18 gemeinsam, d. h., simultan mit dem Aktor 42 bewegt wird, so dass ein Abstand zwischen dem Array 14 und der Strahlumlenkeinrichtung konstant bleibt, oder kompensiert wird. Das bedeutet, dass ein Abstand zwischen dem Array 14 und der Strahlumlenkeinrichtung 18 unverändert bleiben kann und/oder dass die Strahlumlenkeinrichtung 18 gleichzeitig oder zeitversetzt in einem gleichen oder vergleichbaren Umfang wie die Fokussierungsbewegung bewegt wird, so dass der Abstand zwischen Array 14 und der Strahlumlenkeinrichtung 18 zumindest zu einem Zeitpunkt einer Aufnahme des Gesichtsfeldes durch die Multiaperturabbildungsvorrichtung unverändert verglichen mit einem Abstand vor einer Veränderung des Fokus ist. Alternativ kann die Strahlumlenkeinrichtung 18 ruhend oder von der Autofokusbewegung ausgenommen sein.

Der Aktor 58 kann beispielsweise als piezoelektrischer Aktor, etwa als Biegebalken (etwa ein Bimorph, Trimorph oder dergleichen) ausgeführt sein. Alternativ oder zusätzlich kann die Fokussiereinrichtung 54 einen Tauchspulenantrieb, einen pneumatischen Aktor, einen hydraulischen Aktor, einen Gleichstrommotor, einen Schrittmotor, einen thermisch aktuierbaren Aktor oder Biegebalken, einen elektrostatischen Aktor, einen elektrostriktiven und/oder einen magnetostriktiven Antrieb umfassen.

Wie es im Zusammenhang mit dem Bildstabilisator und einer Anordnung desselben in der Ebene 48 bzw. in einem Bereich zwischen den Ebenen 52a und 52b beschrieben wurde, kann der zumindest eine Aktor 58 der Fokussiereinrichtung 54 zumindest teilweise zwischen den Ebenen 52a und 52b angeordnet sein. Alternativ oder zusätzlich kann der zumindest eine Aktor 58 in einer Ebene angeordnet sein, in welcher der Bildsensor 12, das Array 14 und die Strahlumlenkeinrichtung 18 angeordnet sind. Beispielsweise kann der Aktor 58 der Fokussiereinrichtung 54 entlang der Dickenrichtung 57 senkrecht zu der Ebene 48, in welcher der Bildsensor 12, das Array 14 und die Strahlumlenkeinrichtung 18 angeordnet sind, um höchstens 50 % der Abmessung des Aktors 58 der Fokussiereinrichtung 54 entlang der Dickenrichtung 57 aus dem Bereich zwischen den Ebenen 52a und 52b herausragen. Gemäß Ausführungsbeispielen ragt der Aktor um höchstens 30 % aus dem Bereich zwischen den Ebenen 52a und 52b heraus. Gemäß einem anderen Ausführungsbeispiel ragt der Aktor 54 um höchstens 10 % aus dem Bereich heraus oder befindet sich vollständig innerhalb des Bereichs. Das bedeutet, dass entlang der Dickenrichtung 57 kein zusätzlicher Bauraumbedarf für die Fokussiereinrichtung 54 erforderlich ist, was vorteilhaft ist. Weist beispielsweise das Array 14 ein transparentes Substrat (Träger) 62 mit daran angeordneten Linsen 64a-d auf, so kann eine Abmessung des Arrays 14 und ggf. der Multiaperturabbildungsvorrichtung 30 entlang der Dickenrichtung 57 gering oder minimal sein. Unter Bezugnahme auf Fig. 2a kann dies bedeuten, dass der Quader 55 eine geringe Dicke entlang der Richtung 57 aufweist oder dass die Dicke von dem Substrat 62 unbeeinflusst ist. Das Substrat 62 kann von den für die Abbildung in den einzelnen optischen Kanälen genutzten optischen Strahlengängen passiert werden. Die optischen Kanäle der Multiaperturabbildungsvorrichtung können das Substrat 62 zwischen der Strahlumlenkeinrichtung 18 und einem Bildsensor 12 durchqueren.

Bei den Linsen 64a-d kann es sich beispielsweise im Flüssigkeitslinsen handeln, d.h. ein Aktor kann ausgebildet sein, um die Linsen 64a-d anzusteuern. Flüssigkeitslinsen können ausgebildet sein, um kanalweise individual die Brechkraft und mithin Brennweite und Bildlage anzupassen und zu variieren.

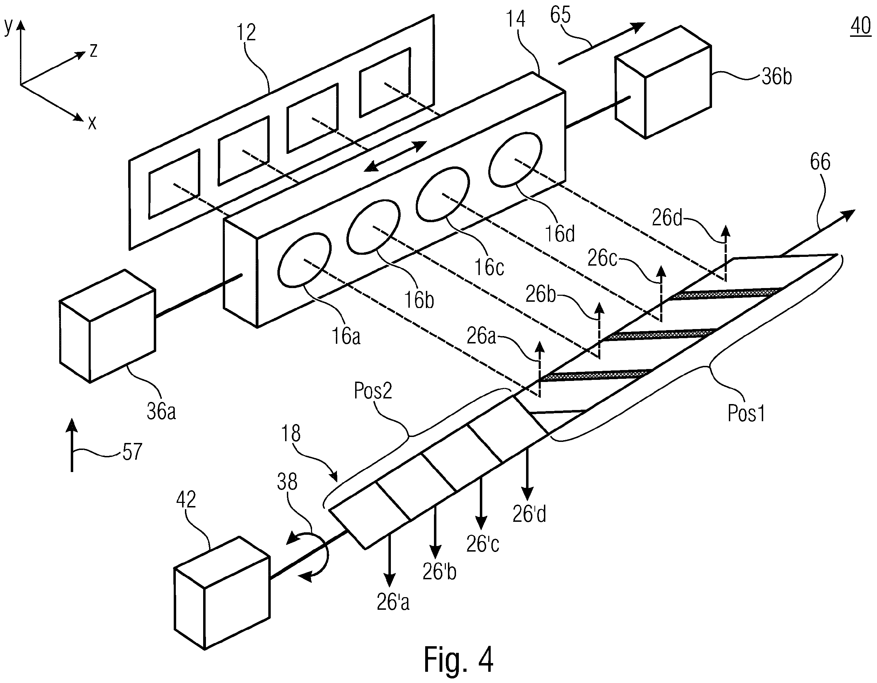

Fig. 4 zeigt eine schematische perspektivische Ansicht einer Multiaperturabbildungsvorrichtung 40 gemäß einem Ausführungsbeispiel. Verglichen mit der Multiaperturabbildungsvorrichtung 10 ist das Array 14 beispielsweise einzeilig ausgebildet, das bedeutet, alle optischen Kanäle 16a-d können entlang einer Zeilenerstreckungsrichtung des Arrays 14 in einer einzigen Zeile angeordnet sein. Die Bezeichnung einzeilig kann dabei eine Abwesenheit weiterer Zeilen bedeuten. Eine einzeilige Ausführung des Arrays 14 ermöglicht eine geringe Abmessung des Arrays und möglicherweise der Multiaperturabbildungsvorrichtung 40 entlang der Dickenrichtung 57.

Die Multiaperturabbildungsvorrichtung 40 kann ausgebildet sein, um basierend auf der Strahlumlenkeinrichtung 18 Gesichtsfelder in voneinander verschiedenen Richtungen zu erfassen. Beispielsweise kann die Strahlumlenkeinrichtung eine erste Position oder Stellung Pos1 und eine zweite Position oder Stellung Pos2 aufweisen. Die Strahlumlenkeinrichtung kann zwischen der ersten Stellung Pos1 und der zweiten Stellung Pos2 basierend auf einer translatorischen oder rotatorischen Bewegung umschaltbar sein. Bspw. kann die Strahlumlenkeinrichtung 18 entlang der Zeilenerstreckungsrichtung z des einzeiligen Arrays 14 translatorisch bewegbar sein, wie es durch eine translatorische Bewegung 66 angedeutet ist. Die translatorische Bewegung 66 kann bspw. im Wesentlichen parallel zu einer Zeilenerstreckungsrichtung 65 angeordnet sein, entlang derer die zumindest eine Zeile des Arrays 14 angeordnet ist. Die translatorische Bewegung kann bspw. nutzbar sein, um unterschiedliche Facetten vor den Optiken der optischen Kanäle 16a-d zu platzieren, um unterschiedliche Blickrichtungen der Multiaperturabbildungsvorrichtung 40 zu erhalten. Die Strahlumlenkeinrichtung 18 kann ausgebildet sein, um in der ersten Stellung Pos1 die Strahlengänge 26a-d in eine erste Richtung umzulenken, beispielsweise zumindest teilweise in eine positive y-Richtung. Die Strahlumlenkeinrichtung 18 kann ausgebildet sein, um in der zweiten Stellung Pos2 die Strahlengänge 26a-d, d.h. jedes optischen Kanals 16a-d, in eine hiervon verschiedene Richtung, beispielsweise zumindest teilweise entlang der negativen y-Richtung zu lenken. Beispielsweise kann der Aktor 42 ausgebildet sein, um basierend auf einer Bewegung der Strahlumlenkeinrichtung 18 entlang der Bewegungsrichtung 66 die Strahlumlenkeinrichtung 18 von der ersten Stellung Pos1 in die zweite Stellung Pos2 zu bewegen. Der Aktor 42 kann ausgebildet sein, um die translatorische Bewegung entlang der Bewegungsrichtung 66 mit der Rotationsbewegung 38 zu überlagern. Alternativ kann die Multiaperturabbildungsvorrichtung 40 auch einen weiteren Aktor umfassen, der ausgebildet ist, um die Strahlumlenkeinrichtung entlang der Bewegungsrichtung 66 oder entgegengesetzt hierzu zu bewegen.

Wie es im Zusammenhang mit der Fig. 2b beschrieben ist, kann der Aktor 42 ausgebildet sein, um die erste bzw. zweite Stellung der Strahlumlenkeinrichtung 18 basierend auf einer Rotation derselben zu erhalten. Die Bewegung zwischen der ersten Stellung Pos1 und der zweiten Stellung Pos2 kann sowohl für eine Rotationsbewegung zum Umschalten zwischen den Stellungen als auch für die translatorische Bewegung entlang der Richtung 66 mit der Rotationsbewegung 38 überlagerbar sein.

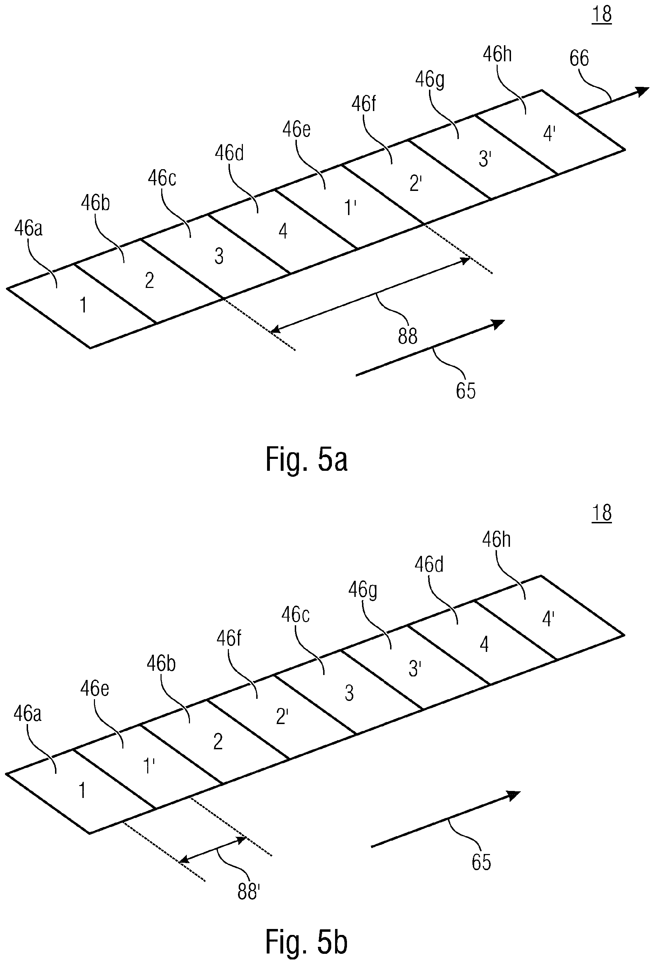

Fig. 5a zeigt eine schematische Darstellung einer Strahlumlenkeinrichtung 18, die als Array von Facetten 46a-h gebildet ist. Ist die Strahlumlenkeinrichtung 18 beispielsweise in der ersten Stellung positioniert, so können die Facetten 46a-d gekennzeichnet mit den Ziffern 1, 2, 3 bzw. 4 Strahlengänge von vier optischen Kanälen in eine erste Richtung umlenken. Weist die Strahlumlenkeinrichtung 18 die zweite Stellung auf, so kann der Strahlengang jedes optischen Kanals basierend auf den Facetten 46e-h in die zweite Richtung umgelenkt werden, wie es durch die Ziffern 1', 2', 3' bzw. 4' gekennzeichnet ist. Die Facetten 46a-d und 46e-h können bspw. als blockweise angeordnet bezeichnet werden. Für die translatorische Bewegung der Strahlumlenkeinrichtung 18 entlang der translatorischen Richtung 66 kann eine Strecke 88 zurückgelegt werden, die im Wesentlichen einer Erstreckungslänge der Anzahl der optischen Kanäle entlang der Zeilenerstreckungsrichtung 65 entspricht. Gemäß dem Ausführungsbeispiel der Fig. 4, ist dies beispielsweise einer Ausdehnung von vier optischen Kanälen entlang der Zeilenerstreckungsrichtung 65. Gemäß einem weiteren Ausführungsbeispiel kann die Anzahl von Strahlumlenkelementen einem Vielfachen der optischen Kanäle verschieden sein. Zumindest ein Strahlumlenkelement kann in einer Stellung der Strahlumlenkeinrichtung ausgebildet oder angeordnet sein, um Strahlengänge von zumindest zwei optischen Kanälen umzulenken.

Fig. 5b zeigt eine schematische Ansicht der Strahlumlenkeinrichtung 18, bei der die Facetten 46a-g verglichen mit der Darstellung in Fig. 5a eine voneinander verschieden Sortierung aufweisen. Die in Fig. 5b dargestellte Strahlumlenkeinrichtung weist eine alternierende Anordnung der optischen Kanäle 46a-g für jeden optischen Kanal auf, wie es durch die Reihenfolge 1, 1', 2, 2', 3, 3', 4 und 4' dargestellt ist. Dies ermöglicht eine Distanz 88', entlang der die Strahlumlenkeinrichtung 18 bewegt wird, um zwischen der ersten Position und der zweiten Position umgeschaltet zu werden. Die Distanz 88' kann verglichen mit der Distanz 88 aus Fig. 5a gering sein. Beispielsweise kann die Distanz 88' im Wesentlichen dem Abstand zwischen zwei benachbarten optischen Kanälen des Arrays 14 entsprechen. Zwei optische Kanäle können bspw. einen Abstand oder einen Zwischenraum zueinander aufweisen, der im Wesentlichen zumindest einer Abmessung einer Facette entlang der Bewegungsrichtung 65 entspricht. Die Distanz 88' kann auch hiervon verscheiden sein, bspw. wenn ein Strahlumlenkelement in einer Stellung der Strahlumlenkeinrichtung ausgebildet oder angeordnet ist, um Strahlengänge von zumindest zwei optischen Kanälen umzulenken.

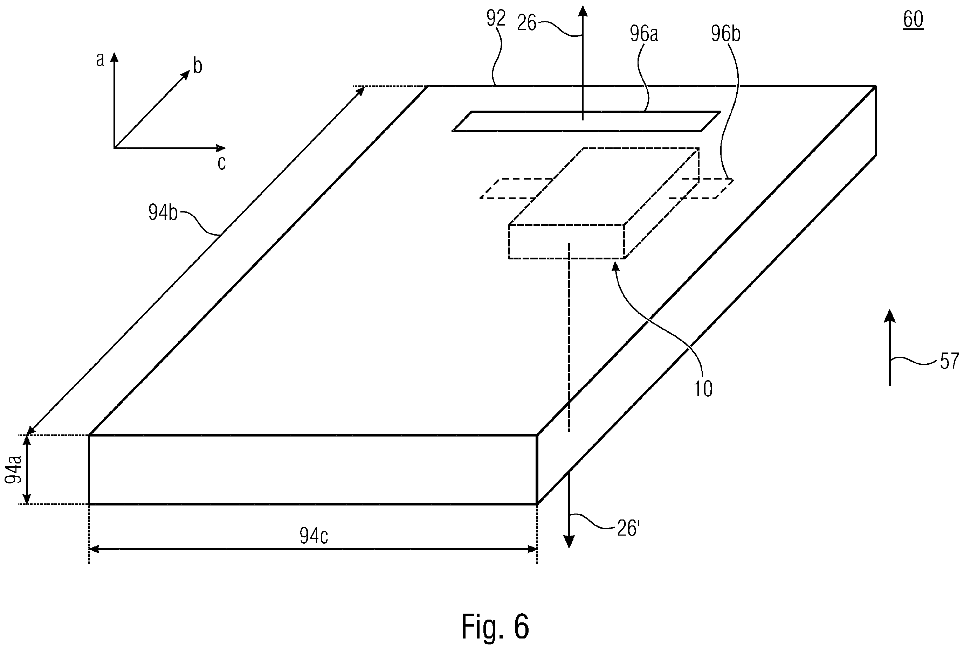

Fig. 6 zeigt eine schematische perspektivische Darstellung eines Abbildungssystems 60 gemäß einem Ausführungsbeispiel. Das Abbildungssystem 60 umfasst die Multiaperturabbildungsvorrichtung 10. Gemäß weiteren Ausführungsbeispielen umfasst das Abbildungssystem 60 alternativ oder zusätzlich zu der Multiaperturabbildungsvorrichtung 10 zumindest eine Multiaperturabbildungsvorrichtung 20, 30 und/oder 40. Das Abbildungssystem 60 umfasst ein flaches Gehäuse 92. Das flache Gehäuse 92 umfasst eine erste Ausdehnung 94a entlang einer ersten Gehäuserichtung a. Das flache Gehäuse 92 umfasst ferner eine zweite Ausdehnung 94b entlang einer zweiten Gehäuserichtung b und eine dritte Ausdehnung 94c entlang einer dritten Gehäuserichtung c. Beispielsweise kann die Gehäuserichtung a parallel zu der Dickenrichtung 57 im Raum angeordnet sein. Die Ausdehnung 94a des flachen Gehäuses 92 entlang der Gehäuserichtung a kann als kleinste Abmessung des flachen Gehäuses 92 verstanden werden. Verglichen mit der kleinsten Ausdehnung können andere Ausdehnungen 94b und/oder 94c entlang anderer Gehäuserichtungen b bzw. c zumindest einen dreifachen Wert, zumindest einen fünffachen Wert oder zumindest einen siebenfachen Wert verglichen mit der Ausdehnung 94a entlang der Gehäuserichtung a aufweisen. Vereinfacht ausgedrückt kann die Ausdehnung 94a kleiner, wesentlich kleiner oder ggf. um eine Größenordnung kleiner sein als andere Ausdehnungen 94b und 94c entlang anderer Gehäuserichtungen b bzw. c.

Das flache Gehäuse 92 kann eine oder mehrere Blenden 96a-b umfassten, durch die der Strahlengang 26 und/oder 26' hindurch umlenkbar ist, beispielsweise basierend auf der Strahlumlenkeinrichtung der Multiaperturabbildungsvorrichtung 10. Die Blenden können bspw. elektrochrome Blenden sein und/oder in einem Bereich der Anzeige angeordnet sein.

Das Abbildungssystem 60 kann als tragbare Vorrichtung ausgebildet sein. Beispielsweise kann das Abbildungssystem 60 eine tragbare Kommunikationseinrichtung, wie etwa ein Mobiltelefon oder ein sogenanntes Smartphone, ein Tablet-Computer oder ein tragbares Musikabspielgerät sein. Das Abbildungssystem 60 kann als Monitor, etwa zur Verwendung in einem Navigations-, Multimedia- oder Televisionssystem implementiert sein. Alternativ oder zusätzlich kann das Abbildungssystem 60 auch hinter reflektierenden Oberflächen, wie etwa einem Spiegel, angeordnet sein.

Im Bereich mobiler Kommunikationsgeräte kann eine Anordnung einer Multiaperturabbildungsvorrichtung 10, 10', 20, 30 und/oder 40 vorteilhaft sein, da basierend auf der Anordnung der Komponenten entlang der langen Gehäuseseiten 94b und/oder 94c eine Ausdehnung der Multiaperturabbildungsvorrichtung entlang der Gehäuserichtung 94a gering sein kann, so dass das Abbildungssystem 60 eine geringe Ausdehnung 94a aufweisen kann. In anderen Worten kann eine relative, zweidimensionale laterale Bewegung von Bildsensor und Objektiv, die in konventionellen Systemen eine zweidimensionale Winkeländerung des Gesichtsfeldes (entspricht einem Scannen) bewirken, durch eine eindimensionale Änderung der Blickrichtung und eine Rotationsbewegung ersetzt werden. Eine eindimensionale Änderung der Blickrichtung kann durch Änderung der Ausrichtung des Spiegels (Strahlumlenkeinrichtung) bezüglich der optischen Achse (Zeilenerstreckungsrichtung) der Abbildungskanäle erfolgen, indem der drehbar gelagerte Spiegel in eine andere Orientierung gebracht wird, wobei die Drehachse des Spiegels senkrecht bzw. nahezu senkrecht zu den optischen Achsen der Abbildungskanäle verlaufen kann. Zur Anpassung der Blickrichtung senkrecht zu der zuvor beschriebenen Richtung können Bildsensor und/oder Arrayobjektiv (Array der optischen Kanäle) lateral zueinander bewegt werden. Im Zusammenspiel beider Bewegungen kann eine zweidimensionale optische Bildstabilisierung erzielt werden.

Um eine geringe Bauhöhe zu ermöglichen, können die zur Realisierung der Bewegung angeordneten Komponenten (beispielsweise Aktoren) und Subsysteme wie etwa eine Bildverarbeitung, ggf. ausschließlich neben, vor und/oder hinter dem durch den Abbildungsstrahlengang definierten Bauraum angeordnet sein, d.h., zwischen den Ebenen 52a und 52b angeordnet sein, und gemäß Ausführungsbeispielen nicht darüber oder darunter. Dies ermöglicht eine räumliche Trennung von Bewegungseinheiten (Aktoren) für die optische Bildstabilisierung. Hierdurch kann eine Verringerung der Anzahl erforderlicher Komponenten erhalten werden und somit ein Herstellungspreis von Kamerasystemen gering sein sowie eine deutliche Verringerung der Bauhöhe verglichen mit konventionellen Aufbauten erzielt werden. Unter Bezugnahme auf Fig. 2a kann ein Unterschied zu bekannten Systemen darin liegen, dass die Linsen (Optiken) der optischen Kanäle den Abstand der Ebenen 52a und 52b im Wesentlichen definieren können. Dies ermöglicht eine geringe Bauhöhe der Vorrichtung, was vorteilhaft ist. In konventionellen Systemen ist eine Hauptebene der Linsen parallel zu den Ebenen 52a und 52b, wohingegen die Hauptebene der Optiken des Arrays orthogonal hierzu angeordnet ist.

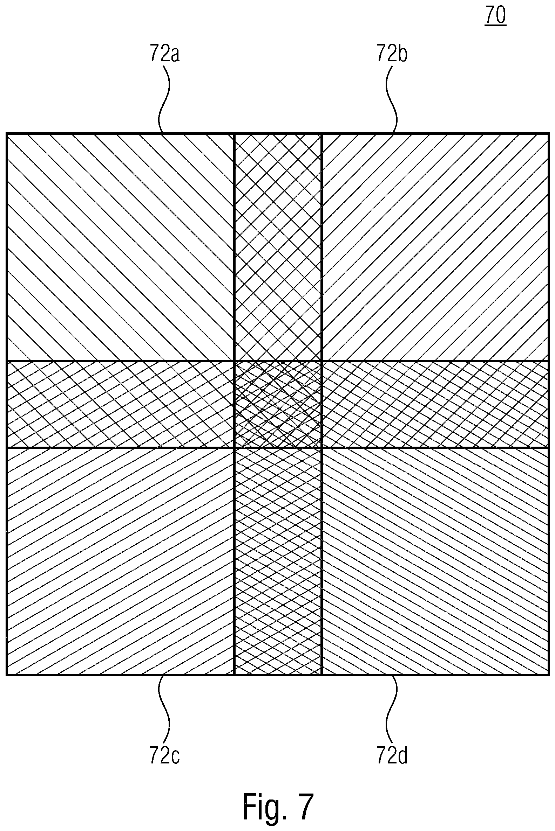

Fig. 7 zeigt eine schematische Darstellung eines Gesamtgesichtsfelds 70, wie es beispielsweise mit einer hierin beschriebenen Multiaperturabbildungsvorrichtung erfassbar ist. Die Strahlengänge der optischen Kanäle der Multiaperturabbildungsvorrichtungen können auf voneinander verschiedene Teilgesichtsfelder 72a-d lenkbar sein, wobei jedem optischen Kanal ein Teilgesichtsfeld 72a-d zugeordnet werden kann. Beispielsweise überlappen die Teilgesichtsfelder 72a-d miteinander, um eine Aneinanderfügung einzelner Teilbilder zu einem Gesamtbild zu ermöglichen. Weist die Multiaperturabbildungsvorrichtung eine von vier verschiede Anzahl von optischen Kanälen auf, kann das Gesamtgesichtsfeld 70 eine von vier verschiedener Anzahl von Teilgesichtsfeldern aufweisen. Alternativ oder zusätzlich kann zumindest ein Teilgesichtsfeld 72a-d von einem zweiten oder einer höheren Anzahl von optischen Kanälen einer höheren Anzahl von Modulen (Multiaperturabbildungsvorrichtungen) erfasst werden, um Stereo-, Trio-,Quattro-Kameras aufzubauen um damit dreidimensionale Objektdaten aufzeichnen zu können. Die Module können einzeln oder als ein zusammenhängendes System ausgelegt sein und an beliebiger Stelle in dem Gehäuse 92 angeordnet sein. Die Bilder der unterschiedlichen Module, die zusammen die Stereo-, Trio- oder Quattro-Kameras bilden, können um Bruchteile eines Pixels verschoben sein, und ausgebildet sein, um Verfahren der Superresolution zu implementieren. Eine Anzahl von optischen Kanälen und/oder eine Anzahl von Multiaperturabbildungsvorrichtungen und/oder eine Anzahl von Teilgesichtsfeldern ist beispielsweise beliebig und kann eine Anzahl von zumindest zwei, zumindest drei, zumindest vier, zumindest zehn, zumindest 20 oder einen noch höheren Wert aufweisen. Die optischen Kanäle der weiteren Zeile können ebenfalls jeweils überlappende Teilbereiche aufnehmen und zusammen das Gesamtgesichtsfeld abdecken. Dies ermöglicht den Erhalt eines Stereo-, Trio-, Quattro-, usw. Aufbaus von Arraykameras, die aus Kanälen bestehen, die teilweise überlappen und innerhalb ihrer Teilgruppierung das Gesamtgesichtsfeld abdecken.

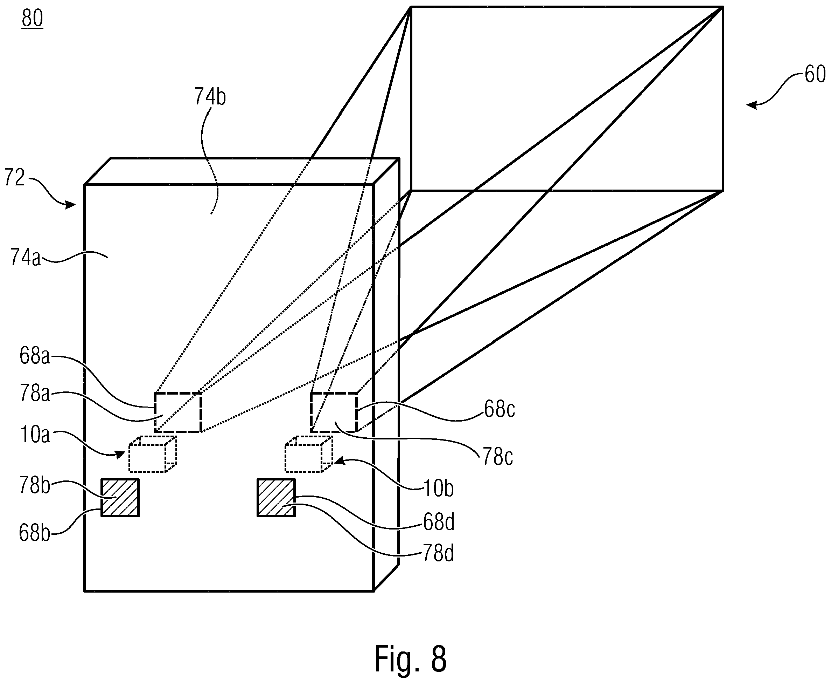

Fig. 8 zeigt eine schematische perspektivische Ansicht einer Vorrichtung 80, die ein Gehäuse 72 und eine erste Multiaperturabbildungsvorrichtung 10a und eine zweite in dem Gehäuse 72 angeordnete Multiaperturabbildungsvorrichtung 10b umfasst. Die Vorrichtung 80 ist um das Gesamtgesichtsfeld 70 stereoskopisch mit den Multiaperturabbildungsvorrichtungen zu erfassen. Das Gesamtgesichtsfeld 70 ist bspw. an einer der Hauptseite 74a abgewandten Hauptseite 74b des Gehäuses angeordnet. Beispielsweise können die Multiaperturabbildungsvorrichtungen 10a und 10b das Gesamtgesichtsfeld 70 durch transparente Bereiche 68a bzw. 68c erfassen, wobei in der Hauptseite 74b angeordnete Blenden 78a und 78c zumindest teilweise transparent sind. In der Hauptseite 74a angeordnete Blenden 78b und 78d können transparenten Bereiche 68b bzw. 68d zumindest teilweise optisch verschließen, so dass ein Umfang von Falschlicht aus einer der Hauptseite 74a zugewandten Seite, das die Aufnahmen der Multiaperturabbildungsvorrichtungen 10a und/oder 10b verfälschen kann, zumindest reduziert ist. Obwohl die Multiaperturabbildungsvorrichtungen 10a und 10b räumlich von einander beabstandet angeordnet dargestellt sind, können die Multiaperturabbildungsvorrichtungen 10a und 10b auch räumlich benachbart oder kombiniert angeordnet sein. Bspw. können die einzeiligen Arrays der Abbildungsvorrichtungen 10a und 10b nebeneinander oder parallel zu einander angeordnet sein. Die einzeiligen Arrays können Zeilen zueinander bilden, wobei jede Multiaperturabbildungsvorrichtung 10a und 10b ein einzeiliges Array aufweist. Die Abbildungsvorrichtungen 10a und 10b können eine gemeinsame Strahlumlenkeinrichtung, und/oder einen gemeinsamen Träger 62 und/oder einen gemeinsamen Bildsensor 12 aufweisen. Alternativ oder zusätzlich zu der Multiaperturabbildungsvorrichtung 10a und/oder 10b kann die Multiaperturabbildungsvorrichtung 10, 10', 20, 30 oder 40 angeordnet sein.

Die transparenten Bereiche 68a-d können zusätzlich mit einer schaltbaren Blende 78a-d ausgestattet sein, die den optischen Aufbau für den Fall der Nicht-Benutzung abdeckt. Die Blende 78a-d kann ein mechanisch bewegtes Teil umfassen. Die Bewegung des mechanisch bewegten Teils kann unter Nutzung eines Aktors erfolgen, wie es beispielsweise für die Aktoren 36 und 45 beschrieben ist. Die Blende 78a-d kann alternativ oder zusätzlich elektrisch steuerbar sein und eine elektrochrome Schicht oder eine elektrochrome Schichtfolge umfassen, d. h., als elektrochrome Blende gebildet sein.

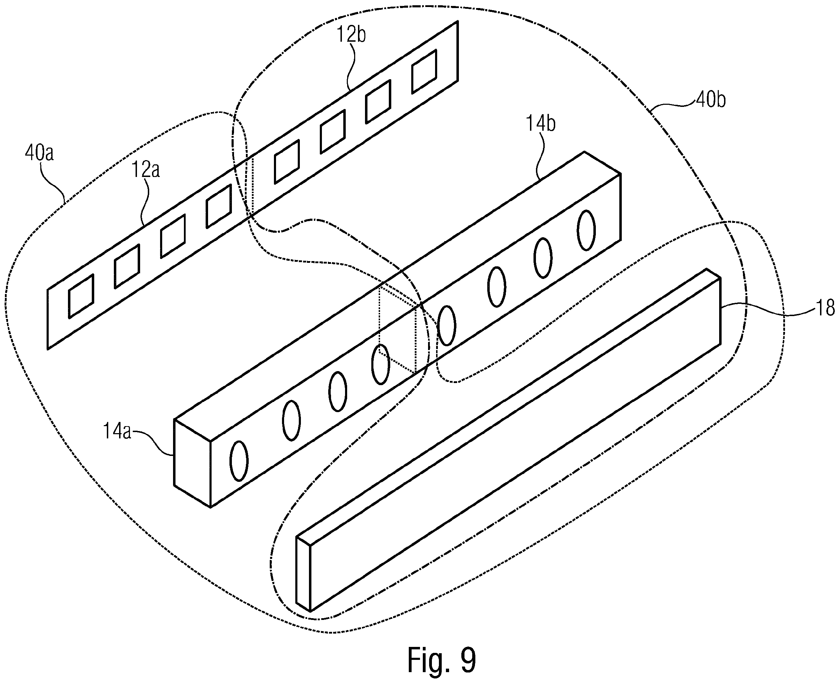

Fig. 9 zeigt einen schematischen Aufbau umfassend eine erste Multiaperturabbildungsvorrichtung 10a und eine zweite Multiaperturabbildungsvorrichtung 10b, wie er bspw. in dem Abbildungssystem 80 angeordnet sein kann. Die Arrays 14a und 14b sind einzeilig gebildet und bilden eine gemeinsame Zeile. Die Bildsensoren 12a und 12b können auf einem gemeinsamen Substrat bzw. auf einem gemeinsamen Schaltungsträger wie einer gemeinsamen Platine oder einem gemeinsamen Flexboard montiert sein. Alternativ können die Bildsensoren 12a und 12b auch von einander verschiedene Substrate umfassen. Verschiedene Mischungen dieser Alternativen sind natürlich ebenfalls möglich, wie etwa Multiaperturabbildungsvorrichtungen umfassend einen gemeinsamen Bildsensor, ein gemeinsames Array und/oder eine gemeinsame Strahlumlenkeinrichtung 18 sowie weitere Multiaperturabbildungsvorrichtungen, die separate Komponenten aufweisen. Vorteilhaft an einem gemeinsamen Bildsensor, einem gemeinsamen Array und/oder einer gemeinsamen Strahlumlenkeinrichtung ist, dass eine Bewegung einer jeweiligen Komponente mit einer großen Präzision durch ansteuern einer geringen Menge von Aktoren erhalten werden kann und eine Synchronisierung zwischen Aktoren reduziert oder vermieden werden kann. Ferner kann eine hohe thermische Stabilität erhalten werden. Alternativ oder zusätzlich können auch andere und/oder von einander verschiedene Multiaperturabbildungsvorrichtungen 10, 10', 20, 30 und/oder 40 ein gemeinsames Array, einen gemeinsamen Bildsensor und/oder eine gemeinsame Strahlumlenkeinrichtung aufweisen.

Hierin beschriebene Ausführungsbeispiele ermöglichen Multiaperturabbildungssysteme mit linearer Kanalanordnung, d.h. einzeilig oder mehrzeilig entlang einer Zeilenerstreckungsrichtung, mit optischer Bildstabilisierung unter Nutzung einachsiger translativer Bewegung zwischen Bildsensor und Abbildungsoptik sowie einachsiger rotativer Bewegung eines strahlumlenkenden Spiegelarrays.

Obwohl vorangehend beschriebene Ausführungsbeispiele so beschrieben sind, dass eine Anzahl von vier optischen Kanälen oder ein Vielfaches hiervon angeordnet sind, können Multiaperturabbildungsvorrichtungen gemäß weiteren Ausführungsbeispielen eine beliebige Anzahl von optischen Kanälen umfassen, beispielsweise können zumindest zwei, zumindest drei, zumindest vier, zumindest zehn oder eine höhere Anzahl von optischen Kanälen angeordnet sein.

Obwohl vorangehend beschriebene Ausführungsbeispiele so beschrieben sind, dass der optische Bildstabilisator 22 den Aktor 36 und den Aktor 42 umfasst, können gemäß weiteren Ausführungsbeispielen die Aktoren 36 und 42 auch als gemeinsamer Aktor ausgebildet sein. Beispielsweise kann eine durch den Aktor erzeugte Bewegung mittels eines Kraft- und/oder Wegumsetzers (Getriebe) auf den Bildsensor 12, das optische Array 14 und/oder die Strahlumlenkeinrichtung 18 geführt werden, um eine jeweilige Bewegung zu erhalten. Alternativ oder zusätzlich können eine oder mehrere Komponenten auch durch mehrere Aktoren bewegt werden, wie es beispielsweise im Zusammenhang mit der Multiaperturabbildungsvorrichtung 40 beschrieben ist.

Der Bildsensor kann beispielsweise als komplementärer Metall-Oxid-Halbleiter (complementary metal-oxide-semiconductor - CMOS) oder einer hiervon verschiedenen Technologie ausgeführt sein. Die optischen Kanäle eines jeweiligen Arrays können so verstanden werden, dass diese einen Bereich definieren, in welchem ein Strahlengang, der auf einen jeweiligen Bildsensorbereich geführt wird, optisch verändert wird. Ein einem Bildsensorbereich zugeordneter Strahlengang kann somit durch den optischen Kanal des Arrays hindurchwandern.

Es wurde bereits weiter oben darauf hingewiesen, dass die Strahlengänge bzw. optischen Achsen ausgehend von der Strahlumlenkeinrichtung in voneinander verschiedene Richtungen gelenkt werden können. Dies kann erhalten werden, indem die Strahlengänge während einer Umlenkung an der Strahlumlenkeinrichtung und/oder durch die Optiken abweichend von einer Parallelität zueinander gelenkt werden. Die Strahlengänge bzw. optischen Achsen können von einer Parallelität vor bzw. ohne Strahlumlenkung abweichend sein. Dieser Umstand wird im Folgenden damit umschrieben, dass die Kanäle mit einer Art Vorab-Divergenz versehen sein können. Mit dieser Vorab-Divergenz der optischen Achsen wäre es möglich, dass sich beispielsweise nicht alle Facettenneigungen von Facetten der Strahlumlenkeinrichtung untereinander unterscheiden, sondern dass manche Gruppen von Kanälen beispielsweise die Facetten mit gleicher Neigung besitzen oder auf diese gelenkt werden. Letztere können dann einstückig bzw. kontinuierlich ineinander übergehend gebildet werden, quasi als eine Facette, die dieser Gruppe von in Zeilenerstreckungsrichtung benachbarten Kanälen zugeordnet ist. Die Divergenz der optischen Achsen dieser Kanäle könnte dann von der Divergenz dieser optischen Achsen stammen, wie sie durch einen lateralen Versatz zwischen optischen Zentren der Optiken der optischen Kanäle und Bildsensorbereichen der Kanäle erzielt wird. Die Vorab-Divergenz könnte sich beispielsweise auf eine Ebene beschränken. Die optischen Achsen könnten beispielsweise vor bzw. ohne Strahlumlenkung in einer gemeinsamen Ebene verlaufen, aber in dieser divergent, und die Facetten bewirken lediglich nur noch eine zusätzliche Divergenz in der anderen Transversalebene, d.h. es sind alle parallel zur Zeilenerstreckungsrichtung und gegeneinander nur noch unterschiedlich zur vorerwähnten gemeinsamen Ebene der optischen Achsen geneigt, wobei hier wiederum mehrere Facetten gleichen Neigung besitzen können bzw. einer Gruppe von Kanälen gemeinsam zugeordnet sein könnten, deren optischen Achsen sich beispielsweise bereits in der vorerwähnten gemeinsamen Ebene der optischen Achsen paarweise vor bzw. ohne Strahlumlenkung unterscheiden. Vereinfachend können die Optiken eine (Vorab-)Divergenz der Strahlengänge entlang einer ersten (Bild-)Richtung und die Strahlumlenkeinrichtung eine Divergenz der Strahlengänge entlang einer zweiten (Bild-)Richtung ermöglichen.

Die erwähnte möglicherweise vorliegende Vorab-Divergenz kann beispielsweise erzielt werden, indem die optischen Zentren der Optiken auf einer Geraden entlang der Zeilenerstreckungsrichtung liegen, während die Zentren der Bildsensorbereiche von der Projektion der optischen Zentren entlang der Normalen der Ebene der Bildsensorbereiche auf Punkte auf einer Geraden in der Bildsensorebene abweichend angerordnet sind, wie z.B. an Punkten, die von den Punkten auf vorerwähnter Gerade in der Bildsensorebene kanalindividuell entlang der Zeilenerstreckungsrichtung und/oder entlang der Richtung senkrecht zur sowohl der Zeilenerstreckungsrichtung als auch der Bildsensornormalen abweichen. Alternativ kann Vorab-Divergenz erzielt werden, indem die Zentren der Bildsensoren auf einer Geraden entlang der Zeilenerstreckungsrichtung liegen, während die Zentren der Optiken von der Projektion der optischen Zentren der Bildsensoren entlang der Normalen der Ebene der optischen Zentren der Optiken auf Punkte auf einer Geraden in der Optikzentrenebene abweichend angerordnet sind, wie z.B. an Punkten, die von den Punkten auf vorerwähnter Gerade in der Optikzentrenebene kanalindividuell entlang der Zeilenerstreckungsrichtung und/oder entlang der Richtung senkrecht zur sowohl der Zeilenerstreckungsrichtung als auch der Normalen der Optikzentrenebene abweichen. Es wird bevorzugt, wenn vorerwähnte kanalindividuelle Abweichung von der jeweiligen Projektion lediglich in Zeilenerstreckungsrichtung verläuft, also die optischen Achsen sich lediglich in einer gemeinsamen Ebene befinden mit einer Vorabdivergenz verwehen werden. Sowohl optische Zentren als auch Bildsensorbereichszentren liegen dann jeweils auf einer Geraden parallel zur Zeilenerstreckungsrichtung, aber mit unterschiedlichen Zwischenabständen. Ein lateraler Versatz zwischen Linsen und Bildsensoren in senkrechter lateraler Richtung zur Zeilenerstreckungsrichtung führte demgegenüber zu einer Vergrößerung der Bauhöhe. Ein reiner In-Ebene-Versatz in Zeilenerstreckungsrichtung ändert die Bauhöhe nicht, aber es resultieren ggf. weniger Facetten und/oder die Facetten weisen nur eine Kippung in einer Winkelorientierung auf, was den Aufbau vereinfacht. So können bspw. jeweils benachbarte optische Kanäle in der gemeinsamen Ebene verlaufende, jeweils gegeneinander schielende, also mit einer Vorab-Divergenz versehene, optische Achsen aufweisen. Eine Facette kann bezüglich einer Gruppe von optischen Kanälen angeordnet, lediglich in einer Richtung geneigt und parallel zur Zeilenerstreckungsrichtung sein.

Ferner könnte es vorgesehen sein, dass manche optische Kanäle dem gleichen Teilgesichtsfeld zugeordnet sind, wie z.B. zum Zwecke der Superresolution bzw. zur Erhöhung der Auflösung, mit welcher das entsprechende Teilgesichtsfeld durch diese Kanäle abgetastet wird. Die optischen Kanäle innerhalb einer solchen Gruppe verliefen dann beispielsweise vor Strahlumlenkung parallel und würden durch eine Facette auf ein Teilgesichtsfeld umgelenkt werden. Vorteilhafterweise lägen Pixelbilder des Bildsensors eines Kanals einer Gruppe in Zwischenpositionen zwischen Bildern der Pixel des Bildsensors eines anderen Kanals dieser Gruppe.

Denkbar wäre beispielsweise auch ohne Superresolutionszwecke, sondern lediglich zu Stereoskopiezwecken eine Ausführung, bei denen eine Gruppe von unmittelbar benachbarten Kanälen in Zeilenerstreckungsrichtung mit ihren Teilgesichtsfeldern das Gesamtgesichtsfeld vollständig abdecken, und dass eine weitere Gruppe einander unmittelbar benachbarter Kanäle das Gesamtgesichtsfeld ihrerseits vollständig abdecken.

Obige Ausführungsbeispiele lassen sich also in Form einer Multiaperturabbildungsvorrichtung und/oder eines eine derartige Multiaperturabbildungsvorrichtung umfassenden Abbildungssystems implementieren, und zwar mit einzeiliger Kanalanordnung, wobei jeder Kanal ein Teilgesichtsfeld eines Gesamtgesichtsfeld überträgt und sich die Teilgesichtsfelder teilweise überlappen. Ein Aufbau mit mehreren solcher Multiaperturabbildungsvorrichtungen für Stereo- Trio-, Quattro usw. Aufbauten für die 3D-Bildaufnahme ist möglich. Die Mehrzahl von Modulen kann dabei als eine zusammenhängende Zeile ausgeführt sein. Die zusammenhängende Zeile könnte identische Aktoren und ein gemeinsames Strahlumlenkelement nutzen. Ein oder mehrere eventuell im Strahlengang vorhandene verstärkende Substrate können sich über die gesamte Zeile, die einen Stereo-, Trio, Quattro-Aufbau bilden kann, erstrecken. Es können Verfahren der Superresolution genutzt werden, wobei mehrere Kanäle dieselben Teilbildbereiche abbilden. Die optischen Achsen können auch bereits ohne Strahlumlenkvorrichtung divergent verlaufen, so dass weniger Facetten auf der Strahlumlenkeinheit benötigt werden. Die Facetten besitzen dann vorteilhafter Weise nur eine Winkelkomponente. Der Bildsensor kann einteilig sein, nur eine zusammenhängende Pixelmatrix oder mehrere unterbrochene aufweisen. Der Bildsensor kann aus vielen Teilsensoren zusammengesetzt sein, die z.B. auf einer Leiterplatte nebeneinander angeordnet sind. Ein Autofokusantrieb kann so ausgeführt sein, dass das Strahlumlenkelement synchron mit den Optiken bewegt wird, oder ruhend ist.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Multiaperturabbildungsvorrichtung (10; 10'; 20; 30; 40) mit:
einem Bildsensor (12);
einem Array (14) von optischen Kanälen (16a-h), wobei jeder optische Kanal (16a-h) eine Optik (17) zur Abbildung eines Teilgesichtsfeldes (72a-d) eines Gesamtgesichtsfeldes (70) auf einen Bildsensorbereich (24a-h) des Bildsensors (12) umfasst;
einer Strahlumlenkeinrichtung (18) zum Umlenken eines Strahlengangs (26a-h) der optischen Kanäle (16a-h); und
einem optischen Bildstabilisator (22) zur Bildstabilisierung entlang einer ersten Bildachse (28) durch Erzeugen einer translatorischen Relativbewegung (34) zwischen dem Bildsensor (12) und dem Array (14) und zur Bildstabilisierung entlang einer zweiten Bildachse (32) durch Erzeugen einer Rotationsbewegung (38) der Strahlumlenkeinrichtung (18).

2. Multiaperturabbildungsvorrichtung gemäß Anspruch 1, wobei der Bildstabilisator (22) zumindest einen Aktor (36, 42) umfasst und so angeordnet ist, dass er zumindest teilweise zwischen zwei Ebenen (52a, 52b) angeordnet ist, die durch Seiten (53a, 53b) eines Quaders (55) aufgespannt werden, wobei die Seiten (53a, 53b) des Quaders (55) zueinander sowie zu einer Zeilenerstreckungsrichtung (35) des Arrays (14) und eines Teils des Strahlengangs (26a-h) der optischen Kanäle (16a-h) zwischen dem Bildsensor (12) und der Strahlumlenkeinrichtung (18) parallel ausgerichtet sind und dessen Volumen minimal ist und dennoch den Bildsensor (12), das Array (14) und die Strahlumlenkeinrichtung (18) umfasst.

3. Multiaperturabbildungsvorrichtung gemäß Anspruch 2, wobei der Bildstabilisator (22) um höchstens 50 % aus dem Bereich zwischen den Ebenen (52a, 52b) herausragt.

4. Multiaperturabbildungsvorrichtung gemäß einem der vorangehenden Ansprüche, die ferner eine Fokussiereinrichtung (54) umfassend zumindest einen Aktor (58) zum Einstellen eines Fokus der Multiaperturabbildungsvorrichtung aufweist, wobei die Fokussiereinrichtung (54) so angeordnet ist, dass sie zumindest teilweise zwischen zwei Ebenen (52a, 52b) angeordnet ist, die durch Seiten (53a, 53b) eines Quaders (55) aufgespannt werden, wobei die Seiten (53a, 53b) des Quaders (55) zueinander sowie zu einer Zeilenerstreckungsrichtung (35) des Arrays (14) und eines Teils des Strahlengangs (26a-h) der optischen Kanäle (16a-h) zwischen dem Bildsensor (12) und der Strahlumlenkeinrichtung (18) parallel ausgerichtet sind und dessen Volumen minimal ist und dennoch den Bildsensor (12), das Array (14) und die Strahlumlenkeinrichtung (18) umfasst.

5. Multiaperturabbildungsvorrichtung gemäß Anspruch 4, wobei die Fokuseinrichtung (54) einen Aktor 58 zum Bereitstellen einer Relativbewegung zwischen einer Optik (17) eines der optischen Kanäle (16a-h) und dem Bildsensor (12) umfasst.

6. Multiaperturabbildungsvorrichtung gemäß Anspruch 5, wobei die Fokussiereinrichtung (54) ausgebildet ist, um die Relativbewegung zwischen der Optik (17) eines der optischen Kanäle (16a-h) und dem Bildsensor (12) unter Ausführung einer zu der Relativbewegung simultanen Bewegung der Strahlumlenkeinrichtung (18) auszuführen.

7. Multiaperturabbildungsvorrichtung gemäß einem der Ansprüche 4 bis 6, wobei die Fokussiereinrichtung (54) so angeordnet ist, dass sie um höchstens 50 % aus dem Bereich zwischen den Ebenen (52a, 52b) herausragt.

8. Multiaperturabbildungsvorrichtung gemäß einem der vorangehenden Ansprüche, wobei das Array (14) einzeilig gebildet ist.

9. Multiaperturabbildungsvorrichtung gemäß einem der vorangehenden Ansprüche, wobei die Strahlumlenkeinrichtung (18) eine erste Stellung (Pos1) und eine zweite Stellung (Pos2) aufweist zwischen denen die Strahlumlenkeinrichtung (18) entlang einer Zeilenerstreckungsrichtung (35) des Arrays (14) translatorisch bewegbar ist, wobei die Strahlumlenkeinrichtung (18) so ausgebildet ist, dass sie in der ersten Stellung (Pos1) und in der zweiten Stellung (Pos2) den Strahlengang (26a-h) jedes optischen Kanals (16a-h) in eine voneinander verschiedene Richtung umlenkt.

10. Multiaperturabbildungsvorrichtung gemäß Anspruch 9, wobei eine translatorische Bewegungsrichtung (34), entlang der die Strahlumlenkeinrichtung (18) translatorisch bewegbar ist, parallel zu der Zeilenerstreckungsrichtung (35) ist.

11. Multiaperturabbildungsvorrichtung gemäß einem der vorangehenden Ansprüche, wobei die Strahlumlenkeinrichtung (18) als Array von Facetten (46a-h), die entlang der Zeilenerstreckungsrichtung (35) angeordnet sind, gebildet ist.

12. Abbildungssystem (60) mit einer Multiaperturabbildungsvorrichtung (10; 10'; 20; 30; 40) gemäß einem der vorangehenden Ansprüche, wobei das Abbildungssystem (60) als tragbares System ausgebildet ist.

13. Abbildungssystem gemäß Anspruch 12, das zumindest eine weitere Multiaperturabbildungsvorrichtung (10; 10'; 20; 30; 40) aufweist, wobei das Abbildungssystem ausgebildet ist, um ein Gesamtgesichtsfeld (70) zumindest stereoskopisch zu erfassen.

14. Abbildungssystem gemäß Anspruch 12 oder 13, das als Mobiltelefon, Smartphone, Tablet oder Monitor ausgebildet ist.

15. Verfahren zum Bereitstellen einer Multiaperturabbildungsvorrichtung mit folgenden Schritten:
Bereitstellen eines Bildsensors;
Anordnen eines Arrays von optischen Kanälen, wobei jeder optische Kanal eine Optik zur Abbildung eines Teilgesichtsfeldes eines Gesamtgesichtsfeldes auf einen Bildsensorbereich des Bildsensors umfasst;
Anordnen einer Strahlumlenkeinrichtung zum Umlenken eines Strahlengangs der optischen Kanäle; und
Anordnen eines optischen Bildstabilisators zur Bildstabilisierung entlang einer ersten Bildachse durch Erzeugen einer translatorischen Relativbewegung zwischen dem Bildsensor (12) und dem Array und zur Bildstabilisierung entlang einer zweiten Bildachse durch Erzeugen einer Rotationsbewegung der Strahlumlenkeinrichtung.

## Claims

1. Multi-aperture imaging device (10; 10'; 20; 30; 40) comprising:
an image sensor (12);
an array (14) of optical channels (16a-h), wherein each optical channel (16a-h) includes optics (17) for projecting a partial field of view (72a-d) of a total field of view (70) onto an image sensor area (24a-h) of the image sensor (12);
a beam-deflecting means (18) for deflecting an optical path (26a-h) of the optical channels (16a-h); and
an optical image stabilizer (22) for an image stabilization along a first image axis (28) by generating a translatory relative movement (34) between the image sensor (12) and the array (14) and for an image stabilization along a second image axis (32) by generating a rotational movement (38) of the beam-deflecting means (18).

2. Multi-aperture imaging device according to claim 1, wherein the image stabilizer (22) includes at least one actuator (36, 42) and is arranged such that same is at least partially arranged between two planes (52a, 52b) that are spanned by sides (53a, 53b) of a cuboid (55), the sides (53a, 53b) of the cuboid (55) being aligned parallel to each other as well as to a line extension direction (35) of the array (14) and a part of the optical path (26a-h) of the optical channels (16a-h) between the image sensor (12) and the beam-deflecting means (18), and the volume of same being minimal and nevertheless including the image sensor (12), the array (14), and the beam-deflecting means (18).

3. Multi-aperture imaging device according to claim 2, wherein the image stabilizer (22) protrudes from the area between the planes (52a, 52b) by a maximum of 50%.

4. Multi-aperture imaging device according to any of the previous claims, further including a focussing means (54) that comprises at least one actuator (58) for adjusting a focus of the multi-aperture imaging device, wherein the focussing means (54) is arranged such that same is at least partially arranged between two planes (52a, 52b) that are spanned by sides (53a, 53b) of a cuboid (55), the sides (53a, 53b) of the cuboid (55) being aligned parallel to each other as well as to a line extension direction (35) of the array (14) and a part of the optical path (26a-h) of the optical channels (16a-h) between the image sensor (12) and the beam-deflecting means (18), and the volume of the same being minimal and nevertheless including the image sensor (12), the array (14), and the beam-deflecting means (18).

5. Multi-aperture imaging device according to claim 4, wherein the focussing means (54) includes an actuator 58 for providing a relative movement between optics (17) of one of the optical channels (16a-h) and the image sensor (12).

6. Multi-aperture imaging device according to claim 5, wherein the focussing means (54) is configured to perform the relative movement between the optics (17) of one of the optical channels (16a-h) and the image sensor (12) while performing a movement of the beam-deflecting means (18) that is simultaneous to the relative movement.

7. Multi-aperture imaging device according to any of claims 4 to 6, wherein the focussing means (54) is arranged such that same protrudes from the area between the planes (52a, 52b) by a maximum of 50%.

8. Multi-aperture imaging device according to any of the previous claims, wherein the array (14) is formed in a single line.

9. Multi-aperture imaging device according to any of the previous claims, wherein the beam-deflecting means (18) comprises a first position (Pos1) and a second position (Pos2) between which the beam-deflecting means (18) may be moved in a translatory manner along a line extension direction (35) of the array (14), the beam-deflecting means (18) being configured to deflect, in the first position (Pos1) and in the in second position (Pos2), the optical path (26a-h) of each optical channel (16a-h) in mutually different directions.

10. Multi-aperture imaging device according to claim 9, wherein a translatory direction of movement (34) along which the beam-deflecting means (18) may be moved in a translatory manner is parallel to the line extension direction (35).

11. Multi-aperture imaging device according to any of the previous claims, wherein the beam-deflecting means (18) is formed as an array of facets (46a-h) that are arranged along the line extension direction (35).

12. Imaging system (60) having a multi-aperture imaging device (10; 10'; 20; 30; 40) according to any of the previous claims, wherein the imaging system (60) is implemented as a portable system.

13. Imaging system according to claim 12, comprising at least one further multi-aperture imaging device (10; 10'; 20; 30; 40), wherein the imaging system is configured to detect a total field of view (70) at least stereoscopically.

14. Imaging system according to claim 12 or 13 that is implemented as mobile phone, smartphone, tablet, or monitor.

15. Method for providing a multi-aperture imaging device, comprising:
providing an image sensor;
arranging an array of optical channels, wherein each optical channel includes optics for projecting a partial field of view of a total field of view onto an image sensor area of the image sensor;
arranging a beam-deflecting means for deflecting an optical path of the optical channels; and
arranging an optical image stabilizer for an image stabilization along a first image axis by generating a translatory relative movement between the image sensor (12) and the array and for image stabilization along a second image axis by generating a rotational movement of the beam-deflecting means.

## Revendications

1. Dispositif de reproduction multi-ouverture (10; 10'; 20; 30; 40) avec:
un capteur d'image (12);
un réseau (14) de canaux optiques (16a à h), où chaque canal optique (16a à h) comporte une optique (17) pour la reproduction d'un champ de vision partiel (72a à d) d'un champ de vision total (70) sur une zone de capteur d'image (24a à h) du capteur d'image (12);
un moyen de déviation de faisceau (18) destiné à dévier un trajet de faisceau (26a à h) des canaux optiques (16a à h); et
un stabilisateur d'image optique (22) destiné à stabiliser une image le long d'un premier axe d'image (28) en générant un mouvement relatif de translation (34) entre le capteur d'image (12) et le réseau (14) et à stabiliser une image le long d'un deuxième axe d'image (32) en générant un mouvement de rotation (38) du moyen de déviation de faisceau (18).

2. Dispositif de reproduction multi-ouverture selon la revendication 1, dans lequel le stabilisateur d'image (22) comporte au moins un actionneur (36, 42) et est disposé de sorte qu'il soit disposé au moins partiellement entre deux plans (52a, 52b) qui sont délimités par les côtés (53a, 53b) d'un parallélépipède (55), où les côtés (53a, 53b) du parallélépipède (55) sont orientés parallèles entre eux ainsi qu'à une direction d'extension de rangées (35) du réseau (14) et d'une partie du trajet de faisceau (26a à h) des canaux optiques (16a à h) entre le capteur d'image (12) et le moyen de déviation de faisceau (18) et dont le volume est minimal et comporte néanmoins le capteur d'image (12), le réseau (14) et le moyen de déviation de faisceau (18).

3. Dispositif de reproduction multi-ouverture selon la revendication 2, dans lequel le stabilisateur d'image (22) ressort de tout au plus 50% de la zone située entre les plans (52a, 52b).

4. Dispositif de reproduction multi-ouverture selon l'une quelconque des revendications précédentes, qui présente par ailleurs un moyen de focalisation (54) comportant au moins un actionneur (58) destiné à régler un foyer du dispositif de reproduction multi-ouverture, où le moyen de focalisation (54) est disposé de sorte qu'il soit disposé au moins partiellement entre deux plans (52a, 52b) qui sont délimités par les côtés (53a, 53b) d'un parallélépipède (55), où les côtés (53a, 53b) du parallélépipède (55) sont orientés parallèles entre eux ainsi que par rapport à une direction d'extension de rangées (35) du réseau (14) et à une partie du trajet de faisceau (26a à h) des canaux optiques (16a à h) entre le capteur d'image (12) et le moyen de déviation de faisceau (18) et dont le volume est minimal et comporte néanmoins le capteur d'image (12), le réseau (14) et le moyen de déviation de faisceau (18).

5. Dispositif de reproduction multi-ouverture selon la revendication 4, dans lequel le moyen de focalisation (54) comporte un actionneur 58 destiné à mettre à disposition un mouvement relatif entre une optique (17) de l'un des canaux optiques (16a à h) et le capteur d'image (12).

6. Dispositif de reproduction multi-ouverture selon la revendication 5, dans lequel le moyen de focalisation (54) est réalisé pour effectuer le mouvement relatif entre l'optique (17) de l'un des canaux optiques (16a à h) et le capteur d'image (12) en effectuant un mouvement du moyen de déviation de faisceau (18) simultané au mouvement relatif.

7. Dispositif de reproduction multi-ouverture selon l'une des revendications 4 à 6, dans lequel le moyen de focalisation (54) est disposé de sorte qu'il ressorte de tout au plus 50% de la zone située entre les plans (52a, 52b).

8. Dispositif de reproduction multi-ouverture selon l'une des revendications précédentes, dans lequel le réseau (14) est formé d'une seule rangée.

9. Dispositif de reproduction multi-ouverture selon l'une des revendications précédentes, dans lequel le moyen de déviation de faisceau (18) présente une première position (Pos1) et une deuxième position (Pos2) entre lesquelles le moyen de déviation de faisceau (18) peut se déplacer en translation dans une direction d'extension de rangées (35) du réseau (14), dans lequel le moyen de déviation de faisceau (18) est conçu de sorte qu'il dévie, dans la première position (Pos1) et dans la deuxième position (Pos2), le trajet de faisceau (26a à h) de chaque canal optique (16a à h) dans une direction différente l'une de l'autre.

10. Dispositif de reproduction multi-ouverture selon la revendication 9, dans lequel une direction de mouvement de translation (34) dans laquelle le moyen de déviation de faisceau (18) peut se déplacer en translation, est parallèle à la direction d'extension de rangées (35).

11. Dispositif de reproduction multi-ouverture selon l'une des revendications précédentes, dans lequel le moyen de déviation de faisceau (18) est formé sous forme de réseau de facettes (46a à h) qui sont disposées dans la direction d'extension de rangées (35).

12. Système de reproduction (60) avec un dispositif de reproduction multi-ouverture (10; 10'; 20; 30; 40) selon l'une des revendications précédentes, dans lequel le système de reproduction (60) est réalisé sous forme de système portable.

13. Système de reproduction selon la revendication 12, qui présente au moins un autre dispositif de reproduction multi-ouverture (10; 10'; 20; 30; 40), dans lequel le système de reproduction est conçu pour capturer au moins de manière stéréoscopique un champ de vision total (70).

14. Système de reproduction selon la revendication 12 ou 13, qui est réalisé sous forme de téléphone mobile, de smartphone, de tablette ou de moniteur.

15. Procédé de fourniture d'un appareil de reproduction multi-ouverture aux étapes suivantes consistant à:
prévoir un capteur d'image;
disposer un réseau de canaux optiques, où chaque canal optique comporte une optique pour la reproduction d'un champ de vision partiel d'un champ de vision total sur une zone de capteur d'image;
disposer un moyen de déviation de faisceau destiné à dévier un trajet de faisceau des canaux optiques; et
disposer un stabilisateur d'image optique destiné à stabiliser une image le long d'un premier axe d'image en générant un mouvement relatif de translation entre le capteur d'image (12) et le réseau et à stabiliser une image le long d'un deuxième axe d'image en générant un mouvement de rotation du moyen de déviation de faisceau.
